# EUROPEAN PATENT APPLICATION

(11) **EP 4 095 881 A1**
(43) Date of publication of application: **30.11.2022**
(21) Application number: 21175823.0
(22) Date of filing: 25.05.2021
(51) Int. Cl.: H01J 37/28, H01J 37/12, H01J 37/317

(54) **CHARGED PARTICLE DEVICE**

(71) Applicant: ASML Netherlands B.V., 5500 AH Veldhoven (NL)
(72) Inventor: MANGNUS, Albertus, Victor, Gerardus, 5500 AH Veldhoven (NL)
(74) Representative: ASML Netherlands B.V.

(57) **Abstract**

The present invention provides a charged particle optical device for a charged particle system. The device projects an array of charged particle beams towards a sample. The device comprises a control lens array to control a parameter of the array of beams; and an objective lens array to project the array of beams onto the sample, the objective lens array being downbeam of the control lens. The objective lens array comprises: an upper electrode; and a lower electrode arrangement that comprises an up-beam electrode and a down-beam electrode. The device is configured to apply an upper potential to the upper electrode, an up-beam potential to the up-beam electrode and a down-beam potential to the down-beam electrode. The potentials are controlled to control the landing energy of the beams on the sample and. to maintain focus of the beams on the sample at the landing energies.

## Description

### FIELD

The embodiments provided herein generally relate to charged particle optical devices and methods of projecting charged particles, and particularly to devices and methods that use multiple beams of charged particles.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause signal charged particles to be emitted from the surface, such as secondary electrons, backscattered electrons or Auger electrons. The generated secondary electrons may be emitted from the material structure of the sample. By scanning the primary electron beam as the probing spot over the sample surface, signal charged particles can be emitted across the surface of the sample. By collecting these emitted signal charged particles from the sample surface, a pattern inspection tool may obtain data relating to the material structure of the surface of the sample, e.g. which may be used to form an image representing characteristics of the material structure of the sample surface.

There is a general need to improve the throughput and other characteristics of charged particle optical devices. In particular, it is desirable to be able to control the landing energy of the electrons incident on the sample in a convenient manner.

### SUMMARY

It is an object of the present disclosure to provide embodiments that support improvement of throughput or other characteristics of charged particle optical devices.

According to an embodiment of the invention, there is provided a charged particle optical device for a charged particle system, the device being configured to project an array of charged particle beams towards a sample, the device comprising: a control lens array configured to control a parameter of the array of beams; and an objective lens array configured to project the array of beams onto the sample, the objective lens array being downbeam of the control lens and comprising: an upper electrode; and a lower electrode arrangement comprising an up-beam electrode and a down-beam electrode, wherein the device is configured to apply an upper potential to the upper electrode, an up-beam potential to the up-beam electrode and a down-beam potential to the down-beam electrode, and is configured to control the up-beam potential and the down-beam potential to vary and/or set the landing energy of the beams on the sample and. to maintain focus of the beams on the sample at different landing energies.

According to an embodiment of the invention, there is provided a charged particle optical device for a charged particle system, the device being configured to project an array of charged particle beams towards a sample, the device comprising: an objective lens array configured to project the array of beams onto the sample, the objective lens array being proximate to the sample and comprising: an upper electrode; and a lower electrode arrangement comprising an up-beam electrode and a down-beam electrode, the device being configured to apply an upper potential to the upper electrode, an up-beam potential to the up-beam electrode and a down-beam potential to the down-beam electrode, and being configured to control a difference between the up-beam potential and the down-beam potential to vary and/or set the landing energy of the beams on the sample, wherein the device is configured in operation to have a difference in magnitude between the up-beam potential and the down-beam potential less than a difference in magnitude between the up-beam potential and the upper potential.

According to an embodiment of the invention, there is provided a charged particle optical device for a charged particle system, the device being configured to project an array of charged particle beams towards a sample, the device comprising: an objective lens array configured to project the array of beams onto the sample, the objective lens being proximate to the sample and comprising: an upper electrode; and a lower electrode arrangement comprising an up-beam electrode and a down-beam electrode, the device being configured to apply an upper potential to the upper electrode, an up-beam potential to the up-beam electrode and a down-beam potential to the down-beam electrode, wherein a distance between the up-beam electrode and the down-beam electrode is smaller than a distance between the upper electrode and the lower electrode arrangement.

According to an embodiment of the invention, there is provided a charged particle optical device for a charged particle system, the device being configured to project an array of charged particle beams along beams paths towards a sample, the device comprising: an objective lens array configured to project the array of beams onto the sample, the objective lens being proximate to the sample and comprising: an upper electrode; and a lower electrode arrangement comprising an up-beam electrode and a down-beam electrode, the device being configured to apply an upper potential to the upper electrode, an up-beam potential to the up-beam electrode and a down-beam potential to the down-beam electrode, wherein a distance between the upper electrode and the lower electrode arrangement and a dimension of the lower electrode arrangement along the beam paths are substantially the same.

According to an embodiment of the present invention, there is provided a charged particle optical device for a charged particle system, the device being configured to project an array of charged particle beams towards a sample, the device comprising: an objective lens array configured to project the array of beams onto the sample, the objective lens being proximate to the sample and comprising: an upper electrode; and a lower electrode arrangement comprising an up-beam electrode and a down-beam electrode, the device being configured to apply an upper potential to the upper electrode, an up-beam potential to the up-beam electrode and a down-beam potential to the down-beam electrode, and being configured to control the up-beam potential and the down-beam potential, wherein the up-beam potential and the down-beam potential of different objective lenses across the objective lens array are configured to be set respectively to correct for focus variations between the different objective lenses in the array.

According to an embodiment of the present invention, there is provided a charged particle optical device for a charged particle system, the device being configured to project an array of charged particle beams towards a sample, the device comprising: an objective lens array configured to project the array of beams onto the sample, the objective lens being proximate to the sample and comprising: an upper electrode; and a lower electrode arrangement comprising an up-beam electrode and a down-beam electrode, the device being configured to apply an upper potential to the upper electrode, an up-beam potential to the up-beam electrode and a down-beam potential to the down-beam electrode, and being configured to control the up-beam potential and the down-beam potential, wherein the potential on the up-beam electrode is configured to be controllably adjusted across the objective lens array to correct for focus variations between the different objective lenses in the array.

According to an embodiment of the present invention, there is provided a method of projecting an array of charged particle beams towards a sample in a charged particle optical device, the device comprising: a control lens array configured to control a parameter of the array of beams; and an objective lens array configured to project the array of beams onto the sample, the objective lens being down-beam of the control lens and comprising an upper electrode and a lower electrode arrangement comprising an up-beam electrode and a down-beam electrode, the method comprising: providing the array of beams; applying an upper potential to the upper electrode, an up-beam potential to the up-beam electrode and a down-beam potential to the down-beam electrode; and controlling the up-beam potential and the down-beam potential so as to vary and/or set the landing energy of the beams on the sample and to maintain focus of the beams on the sample at different landing energies

### BRIEF DESCRIPTION OF FIGURES

The above and other embodiments of the present disclosure will become more apparent from the description of exemplary embodiments, taken in conjunction with the accompanying drawings.
**FIG. 1** is a schematic diagram illustrating an exemplary charged particle beam inspection apparatus.
**FIG. 2** is a schematic diagram illustrating an exemplary multi-beam apparatus that is part of the exemplary charged particle beam inspection apparatus of **FIG. 1****.**
**FIG. 3** is a schematic diagram of an exemplary multi-beam apparatus according to an embodiment.
**FIG. 4** is a graph of landing energy vs. resolution of an exemplary arrangement.
**FIG. 5** is an enlarged diagram of a control lens and an objective lens according to an embodiment.
**FIG. 6** is a schematic cross-sectional view of an objective lens according to an embodiment.
**FIG. 7A** and **FIG. 7B** are schematic cross-sectional views of an objective lens according to embodiments.
**FIG. 8** is a schematic cross-sectional view of portions of electrodes forming objective lenses with a final beam-limiting aperture array according to an embodiment.
**FIG. 9** is a schematic magnified top sectional view relative to plane A-A in **FIG. 8** showing an aperture in the final beam-limiting aperture array
**FIG. 10** is a schematic diagram of an exemplary charged particle system according to an embodiment comprising a macro collimator and macro scan deflector.
**FIG. 11** is a schematic diagram of an exemplary charged particle system according to an embodiment comprising a collimator element array and a scan-deflector array.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of devices and methods consistent with the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%,. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can obtain data of the scanned area of the sample, which may for example, be used to create an image of the scanned area of the sample. For high throughput inspection, some of the inspection apparatuses use multiple focused beams of primary electrons, i.e. a multi-beam. The component beams of the multi-beam may be referred to interchangeably as beams, sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

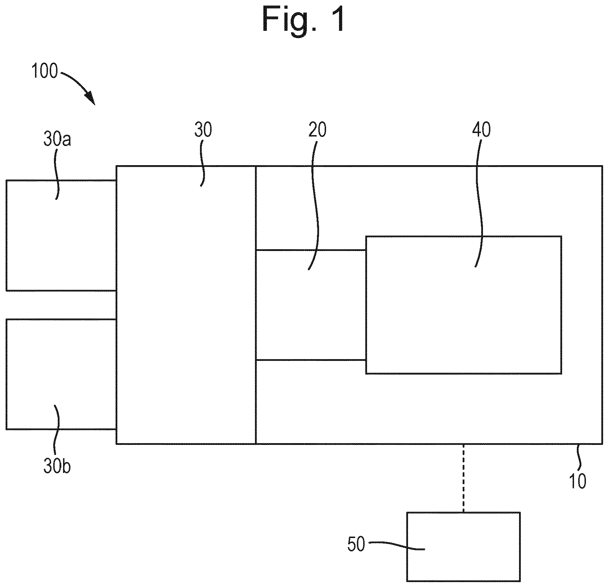

Reference is now made to FIG. 1, which is a schematic diagram illustrating an exemplary charged particle beam inspection apparatus 100. The charged particle beam inspection apparatus 100 is an example of a charged particle system. The charged particle beam inspection apparatus 100 of FIG. 1 includes a main chamber 10, a load lock chamber 20, an electron beam tool 40, an equipment front end module (EFEM) 30 and a controller 50. Electron beam tool 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure around the sample reaches a second pressure lower than the first pressure. After reaching the second pressure, the sample is transported to the electron beam tool 40 by which it may be inspected. An electron beam tool 40 may comprise a charged particle optical device as described below, e.g. multi-beam electron-optical apparatus.

Controller 50 is electronically connected to electron beam tool 40. Controller 50 may be a processor (such as a computer) configured to control the charged particle beam inspection apparatus 100. Controller 50 may also include a processing circuitry configured to execute various signal and/or image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection tool, it should be noted that aspects of the disclosure in their broadest sense are not limited to a chamber housing an electron beam inspection tool. Rather, it is appreciated that the foregoing principles may also be applied to other tools and other arrangements of apparatus, that operate under the second pressure.

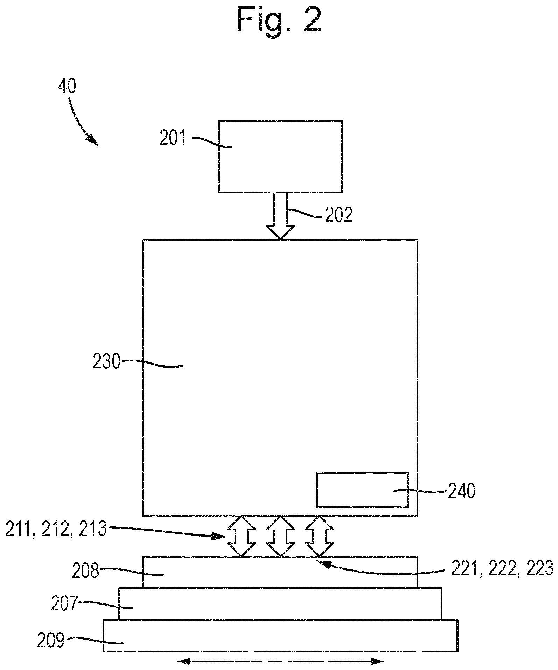

Reference is now made to **FIG. 2****,** which is a schematic diagram illustrating an exemplary electron beam tool 40 including a multi-beam inspection tool that is part of the exemplary charged particle beam inspection apparatus 100 of **FIG. 1****.** Multi-beam electron beam tool 40 (also referred to herein as apparatus 40) comprises an electron source 201, a projection apparatus 230, a motorized stage 209, and a sample holder 207. The electron source 201 and projection apparatus 230 may together be referred to as an illumination apparatus. The sample holder 207 is supported by motorized stage 209 so as to hold a sample 208 (e.g., a substrate or a mask) for inspection. Multi-beam electron beam tool 40 may further comprises an electron detection device 240.

The charged particle system may comprise source 201. During operation, the source 201 provides a beam of charged particles (e.g. electrons). For example, the source 201 may comprise a cathode (not shown) and an extractor or anode (not shown), and the source may emit electrons as primary electrons from the cathode. The primary electrons are extracted or accelerated by the extractor and/or the anode to form a primary electron beam 202. Instead of the electron source 201, a charged particle source may be provided. The multi-beam focused on the sample 208 is derived from the beam provided by the source 201. Sub-beams may be derived from the beam, for example, using a beam limiter defining an array of beam-limiting apertures. The source 201 is desirably a high brightness thermal field emitter with a good compromise between brightness and total emission current.

Projection apparatus 230 is configured to convert primary electron beam 202 into a plurality of sub-beams 211, 212, 213 (which may otherwise be referred to as beams or beamlets) and to direct each sub-beam onto the sample 208. Although three sub-beams are illustrated for simplicity, there may be many tens, many hundreds or many thousands of sub-beams.

Controller 50 may be connected to various parts of the electron beam tool 40, such as the electron source 201, electron detection device 240, projection apparatus 230, and/or the motorized stage 209. Controller 50 may perform various image and/or signal processing functions. Controller 50 may also generate various control signals to govern operations of the charged particle system, and may be used to generate various control signals to govern operations of the charged particle optical device.

Projection apparatus 230 may be configured to focus sub-beams 211, 212, and 213 onto a sample 208 for inspection and may form three probe spots 221, 222, and 223 on the surface of sample 208. Projection apparatus 230 may be configured to deflect primary sub-beams 211, 212, and 213 to scan probe spots 221, 222, and 223 across individual scanning areas in a section of the surface of sample 208. In response to incidence of primary sub-beams 211, 212, and 213 on probe spots 221, 222, and 223 on sample 208, signal particles, e.g. electrons, are generated from the sample 208 which may include secondary electrons and backscattered electrons. The secondary electrons typically have electron energy ≤ 50 eV and backscattered electrons typically have electron energy between 50 eV and the landing energy of primary sub-beams 211, 212, and 213. The secondary electrons and the backscattered electrons may otherwise be referred to as, and are interchangeable with, secondary charged particles and backscattered charged particles respectively. The charged particles emitted from the sample, e.g. the secondary electrons and backscattered electrons, may generally be referred to as signal particles, e.g. secondary signal particles and backscattered signal particles.

Electron detection device 240 is configured to detect signal particles, e.g. secondary electrons and/or backscattered electrons, and to generate corresponding signals which are sent to controller 50 or a signal processing system (not shown), e.g. to construct images of the corresponding scanned areas of sample 208. Electron detection device 240 may be incorporated into the projection apparatus 230 as shown in FIG. 2. Electron detection device 240 may be separate from the projection apparatus 230, e.g. with a secondary optical column being provided to direct signal charged particles, e.g. secondary electrons and/or backscattered electrons, to the electron detection device 240. The electron detection device 240 is an example of a charged particle detection device and may be replaced with any appropriate charged particle detection device.

The controller 50 may comprise a data processing system and/or a storage device (not shown). For example, the controller 50 may comprise a processor, computer, server, mainframe host, terminals, personal computer, any kind of mobile computing devices, and the like, or a combination thereof. The data processing system may comprise at least part of the processing function of the controller. Thus, the data processing system may comprise at least one or more processors. The data processing system may be communicatively coupled to electron detection device 240 of the apparatus 40 permitting signal communication, such as an electrical conductor, optical fiber cable, portable storage media, IR, Bluetooth, internet, wireless network, wireless radio, among others, or a combination thereof. The data processing system may receive a signal from electron detection device 240, may process the data comprised in the signal. The data processing system may acquire data relating to a sample based on the signal received from the electron detection device 240. The signal may correspond to a scanning operation using the charged particle sub-beams. The storage may be a storage medium such as a hard disk, flash drive, cloud storage, random access memory (RAM), other types of computer readable memory, and the like. The storage may be coupled with the data processing system and may be used for saving scanned raw data and/or post-processed data.

Additionally or alternatively, the controller 50 may comprise image processing system that includes an image acquirer (not shown). This image processing system may be provided in addition to the data processing system. The image processing system may comprise the data processing system. The image acquirer may comprise at least part of the processing function of the controller. Thus the image acquirer may comprise at least one or more processors. The image acquirer may receive a signal from electron detection device 240, may process the data comprised in the signal (e.g. using the data processing system) and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be coupled with the image acquirer and may be used for saving scanned raw image data as original images, and post-processed images.

The image acquirer may acquire one or more images of a sample based on the data signal. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the signal charged particles, e.g. secondary electrons. The signal charged particle distribution data, collected during a detection time window, can be used in combination with corresponding scan path data of each of primary sub-beams 211, 212, and 213 incident on the sample surface, to obtain data of sample structures under inspection. Data processing may be used, either raw data or processed data, to reveal characteristics and/or defects in the sample 208 (e.g. without generation of images). The data can optionally be used to reconstruct images of these sample structures. The reconstructed images can be used to reveal various features of the internal or external structures of sample 208. The reconstructed images can thereby be used to reveal any defects that may exist in the sample.

The controller 50 may control motorized stage 209 to move sample 208 during inspection of sample 208. The controller 50 may enable motorized stage 209 to move sample 208 in a direction, preferably continuously, for example at a constant speed, at least during sample inspection. The controller 50 may control movement of the motorized stage 209 so that it changes the speed of the movement of the sample 208 dependent on various parameters. For example, the controller 50 may control the stage speed (including its direction) depending on the characteristics of the inspection steps of scanning process.

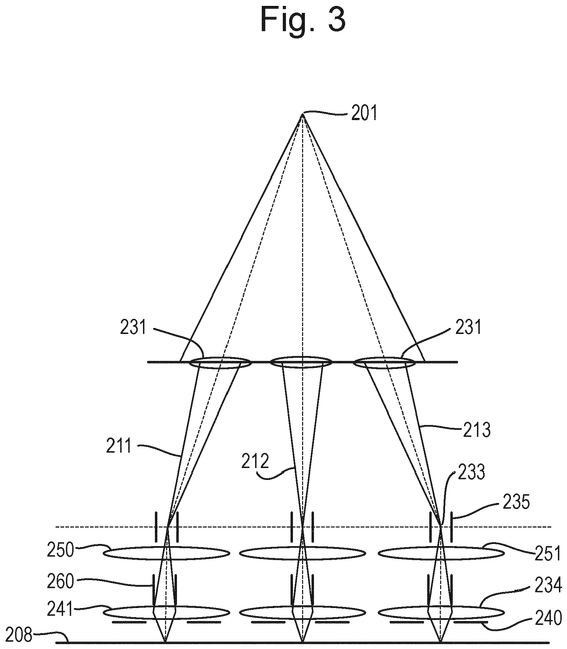

**FIG. 3** is a schematic diagram of an assessment tool. Electron source 201 directs electrons toward an array of condenser lenses 231 forming part of projection system 230. The electron source 201 is desirably a high brightness thermal field emitter with a good compromise between brightness and total emission current. There may be many tens, many hundreds or many thousands of condenser lenses 231. Condenser lenses of array 231 may comprise multi-electrode lenses and have a construction based on EP1602121A1, which is hereby incorporated by reference, in particular in relation to the disclosure of a lens array to split an e-beam into a plurality of sub-beams 211, 212, 213, with the array providing a lens for each sub-beam 211, 212, 213. The condenser lens array 231 may take the form of at least two plates, acting as electrodes, with an aperture in each plate aligned with each other and corresponding to the location of a sub-beam 211, 212, 213. At least two of the plates are maintained during operation at different potentials to achieve the desired lensing effect.

In an arrangement, the condenser lens array 231 is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs charged particles into a respective sub-beam 211, 212, 213 which is focused at a respective intermediate focus 233. Deflectors 235 are provided at the intermediate focuses 233. Deflectors 235 are configured to bend a respective sub-beam 211, 212, 213 by an amount effective to ensure that the principal ray (which may also be referred to as the beam axis) is incident on the sample 208 substantially normally (i.e. at substantially 90° to the nominal surface of the sample). Deflectors 235 may also be referred to as collimators.

Below (i.e. down-beam or further from source 201) deflectors 235 there is a control lens array 250 comprising a control lens for each sub-beam 211, 21, 213. Each control lens comprises at least two electrodes (e.g. two or three electrodes) connected to respective potential sources. Control lens array 250 may comprise two or more (e.g. three) plate electrode arrays connected to respective potential sources. Each plate electrode array may be mechanically connected to, and electrically separated from, an adjacent plate electrode array by an isolating element, such as a spacer, which may comprise ceramic or glass. Electrodes of the control lens array may be connected to the electrically insulating spacer. The control lens array may be configured to control a parameter of the array of beams. A function of control lens array 250 is to optimize the beam opening angle with respect to the demagnification of the beam and/or to control the beam energy delivered to the objective lenses 234, each of which directs a respective sub-beam 211, 212, 213 onto the sample 208.

The control lens array 250 may be associated with an objective lens array 241 (e.g. the two arrays may be positioned close to each other and/or mechanically connected to each other and/or controlled together as a unit). The control lens array 250 may be mechanically connected to, and electrically separated from, the objective lens array 241 by an isolating element, such as a spacer which may comprise ceramic or glass. Each control lens 251 may be associated with a respective objective lens 234. The control lens array 250 is positioned up-beam of the objective lens array 241. The objective lens array 241 may be positioned at or near the base of the electron-optical system. More specifically, the objective lens array 241 may be positioned at or near the base of the projection system 230. The control lenses may pre-focus the sub-beams (e.g. to apply a focusing action to the sub-beams prior to the sub-beams reaching the objective lens array 241). The pre-focusing may reduce divergence of the sub-beams or increase a rate of convergence of the sub-beams. The control lens array 250 is optional, but is preferred for optimizing sub-beams 211, 212, 213 up-beam (i.e. above or closer to source 201) of the objective lens array 241.

The control lens array 250 and the objective lens array 241 may be considered to be an arrangement. The arrangement may be described as four or more lens electrodes that are plates. In the plates are defined apertures, for example as aperture arrays, that are aligned with a number of beams in a corresponding beam array. The electrodes may be grouped into lenses of two or more electrodes for example to provide a control lens array, such as a control lens group, and an objective lens array, such as an objective lens group. In an arrangement, the objective lens group has at least two lens electrodes and the control lens group has at least two lens electrodes.

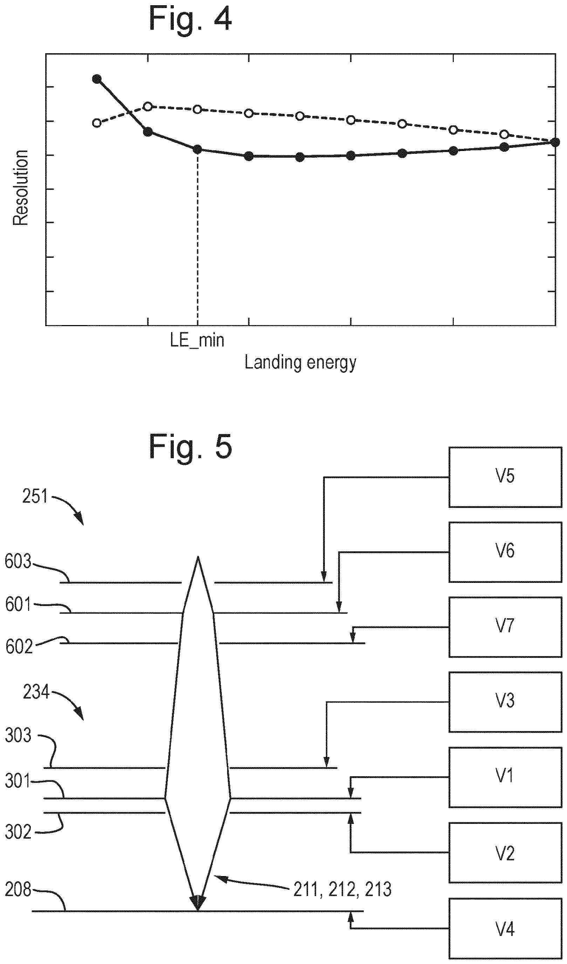

For example, an electrode of the objective lens array 241 furthest from the sample 208, i.e. the up beam most electrode of the objective lens array (which may correspond to upper electrode 303 described below in relation to figure 5), and an electrode of the control lens array 250 closest to the sample 208, i.e. the down beam most electrode of the control lens array 250 (which may correspond to lower electrode 602 described below) may be provided by a common electrode. Thus, the up-beam most electrode lens of the objective lens group is the common electrode being also a member of the down-beam most electrode of the condenser lens group. Although the electrode may be common to both the objective lens array 241 and the control lens array 250, the surfaces of the electrode may belong to different lenses. For example, an up-beam surface of the common electrode forms part of a lens of the control lens array 250 and the down-beam surface of the common electrode forms part of a lens of the objective lens array 241. This approach is beneficial where it is desirable for the control lens array 250 to be positioned close to the objective lens array 241. This is more likely to be the case when a condenser lens array is not present.

The objective lens array 241 is configured to project an array of sub-beams 211, 212, 213 onto the sample 208. An objective lens 234 in the objective lens array 241 may be a micro-lens operating a different sub-beam or group of beams in the multi-beam. The position of each hole in a plate (e.g. an electrode) corresponds to the position of a corresponding hole in the other plate. The corresponding holes operate in use on the same sub-beam or group of beams in the multi-beam.

Electrodes of the objective lens array 241 may be spaced apart by an electrically insulating spacer (not shown). The spacer may be a structural spacer. Electrodes of the objective lens array 241 may be connected to the electrically insulating spacer. The spacer may comprise ceramic or glass, or any other appropriate material.

Optionally, an array of scan deflectors 260 is provided between the control lens array 250 and the array of objective lenses 234. The array of scan deflectors 260 comprises a scan deflector for each sub-beam 211, 212, 213. Each scan deflector is configured to deflect a respective sub-beam 211, 212, 213 in one or two directions so as to scan the sub-beam across the sample 208 in one or two directions.

An electron detection device 240 is provided to detect signal particles, e.g. secondary and/or backscattered electrons emitted from the sample 208. The electron detection device 240 may be positioned between the objective lenses 234 and the sample 208 as shown in FIG. 3. The electron detection device 240 may be provided additionally or alternatively in other positions, as described further below. An exemplary construction of the electron detection device 240, which may be provided as an array of detectors, is described below.

The objective lens 234 may be a deceleration lens, i.e. the objective lens array 241 may decelerate charged particles beams (e.g. the sub-beams 211, 212, 213). A known deceleration lens may be a relatively simple electrostatic lens consisting of two electrodes along an optical axis, with a charged-particle beam passing through the electrodes before being incident on sample 208. The charged-particle beam is decelerated in the objective lens because the lower electrode (i.e. further from source 201) has a lower potential than the upper electrode. The upper electrode voltage is typically taken to be the same as the beam entrance energy (in keV). The overall focal effect of the deceleration lens can be described as the combined result of the aperture lens effects created at the two electrodes by the electric field between them (the electrodes have different potential) and by the decelerating electric field itself.

Generally, the achievable resolution improves for a smaller focal length of the lower electrode aperture lens. The focal length can be made smaller by increasing the voltage difference between the electrodes of the objective lens and decreasing the distance between upper and lower electrodes. In practice this is limited by a maximum voltage, e.g. approximately 30 kV may be a preferred upper limit for the maximum voltage in view of X-ray safety measures. This is also limited by a maximum electric field, e.g. approximately 10 kV/mm may be a preferred upper limit for the electric field because fields going higher than this may increase the risk of electrical breakdown in a vacuum. Thus, these are practical limits for the achievable resolution with a deceleration lens.

To achieve the best resolution for a fixed landing energy in such a known two-electrode objective lens, the thickness of the lower electrode can be optimized in such a way that the distance between the top of the lower electrode (where the main focusing action of the aperture lens takes place) and the sample 208 is about the same as the focal length of this aperture lens. The lower electrode voltage may be approximately the same as the landing energy to have only a small electric field on the sample 208 to prevent damage to the sample 208. For example only, in this instance, the thickness of the lower electrode may be less than approximately 1 mm

It can be beneficial to vary the landing energy of the sub-beams on the sample 208. The landing energy may be varied (i.e. controlled) to obtain information showing contrast in the data (which may, for example, result in imaging contrast). Varying the landing energy may reduce charging, and/or may be beneficial in reducing or preventing damage of the sample 208.

As described above, the geometry of the lower electrode can be optimized for a certain landing energy. For a variable landing energy with the same upper electrode voltage (i.e. same beam entrance energy) the focal length of the lower aperture lens will depend on the landing energy. Thus, when a lower landing energy is used, the focal length decreases and the sub-beam focuses above instead of on the sample 208; when a higher landing energy is used, the focal length increases and the sub-beam focuses below instead of on the sample 208. It is possible to correct the focus by applying different voltages to the lower electrode and the sample 208, i.e. creating another lens field above the sample 208. However, a strong electric field between the lower electrode and the sample may be needed for such focus correction and a large electric field risks damaging the sample 208. Furthermore, such a strong field may affect trajectories of signal charged particles (and particularly secondary electrons) emitted from the sample, which might be detrimental to the detector collection efficiency. The focus could alternatively be corrected by changing the distance between the lower electrode and the sample 208. For example, the sample 208 can be moved upwards or downwards in FIG 2 relative to the objective lens array. However, the distance between the sample 208 and the lower electrode of the objective lens has to be very accurately adjusted which increases complexity of the device and may reduce detector collection efficiency. Thus, the relatively simple two-electrode objective lens may not be well suited for a variable landing energy. For reference, such a two-electrode objective lens may be referred to as the "original electrode geometry".

**FIG. 4** is a graph depicting resolution as a function of landing energy (assuming the beam opening angle/demagnification is re-optimized for changing landing energy). The solid line shows the variation in resolution and landing energy for the original electrode geometry when the bottom most electrode of the objective lens array 241 can be moved relative to the sample 208, i.e. with an adjustable working distance between the objective lens array and the sample 208. As can be seen, the resolution can be kept substantially constant with variation in landing energy down to a minimum value LE_min. Resolution deteriorates below LE_min because, for example, then it is necessary to reduce the lens strength of, and electric fields within, the objective lens 234 in order to maintain a minimum spacing between objective lens and/or detector and the sample 208.

The idea underlying the present invention is to create a three electrode deceleration lens by splitting the lower electrode of a deceleration objective lens into two thinner electrodes to enable a continuously variable landing energy (which may be used at fixed sample distance). The geometry of the set of two thinner electrodes can be deduced from the highest landing energy to be used for the system (discussed in detail below). By using a set of two thinner electrodes (e.g. which may have the same overall thickness as the original thickness needed for the highest landing energy), lower landing energies can be achieved by varying the individual voltages on the two thinner electrodes. The dotted line in FIG. 4 shows the variation in resolution and landing energy for the electrode geometry with these two thinner bottom electrodes when the objective lens array 241 is fixed relative to the sample 2018 (i.e. when the working distance is constant). As can be seen, the resolution is lower at lower landing energy, thus enabling a lower value of LE_min compared to the original electrode geometry.

In an embodiment, a charged particle optical device is provided to project sub-beams 211, 212, 213 towards sample 208. The sub-beams 211, 212, 213 represent, and may interchangeably be referred to as, an array of charged particle beams. The charged particle optical device controls the landing energy of sub-beams 211, 212, 213 on the sample 208. The landing energy can be selected to increase emission and detection of signal particles dependent on the nature of the sample 208 being assessed. The device may be configured to control the landing energy to any desired value within a predetermined range or to a desired one of a plurality of predetermined values.

The device comprises objective lens array 241. Desirably, the landing energy is varied by controlling the energy of charged particles exiting the objective lens 234. The objective lens array 241 comprises an upper electrode and a lower electrode arrangement comprising an up-beam electrode and a down-beam electrode. The lower electrode arrangement may correspond to the split lower electrode described above. Providing the lower electrode arrangement (rather than a single lower electrode as in the original electrode geometry can be beneficial in a number of different ways, and particularly can be used to control the landing energy and/or focus. The objective lens 234 may also be referred to as a refocus lens as it can function to correct the focus position in view of changes in the landing energy.

The device is configured to apply a voltage to electrodes of the objective lens array 241. The device is configured to apply an upper potential to the upper electrode, an up-beam potential to the up-beam electrode, and a down-beam potential to the down-beam electrode. The upper electrode, up-beam electrode and down-beam electrode are each provided with an aperture through which the respective sub-beam propagates.

The device may comprise at least one electric power source. The electric power source may be more generally referred to, and may be interchangeable with, a power supply. At least one power source may be used to set one or more potentials of the device, and particularly, to provide potentials the electrodes of the objective lens array 241. Preferably, the power source sets the relevant potentials using controller 50. At least one electric power source may be configured to apply potentials to electrodes of the control lens array 250.

**FIG. 5** is an enlarged schematic view of one objective lens 234 and one control lens 251. The objective lens 234 comprises the upper electrode 303, the up-beam electrode 301, and the down-beam electrode 302. Voltage sources V3, V1, V2 are configured to apply potentials to the upper electrode, up-beam electrode, and down-beam electrode respectively. Voltage source V4 may be connected to the sample 208 to apply a sample potential. Potentials can be defined relative to the source 201. The control lens 251 comprises a middle electrode 601, a lower electrode 602, and an upper electrode 601 which are connected to voltage sources V6, V7, V5 respectively. Electrodes 601, 602, 603 may be spaced a few millimeters (e.g. 3mm) apart. Desirably, the lower electrode 602 of the control lens and the uppermost electrode of the objective lens (i.e. upper electrode 303) have substantially the same potential. The control lens 251 can be used to control the beam opening angle.

If there is a spacing between the control lens array 250 and the objective lens array 241 (i.e. the gap between lower electrode 602 of the control lens and the upper electrode 303 of the objective lens), then the spacing can be selected from a wide range, e.g. from 2 mm to 200 mm or more. A small separation makes alignment easier whereas a larger separation allows a weaker lens to be used, reducing aberrations.

The control lens array 251 and objective lens array 241 may be spaced apart by an electrically insulating spacer (not shown). The spacer may be a structural spacer. An electrode of the control lens array and/or an electrode of the objective lens array may be connected to the electrically insulating spacer. The spacer may comprise ceramic or glass, or any other appropriate material.

The charged particle device may control (e.g. vary and/or set) the landing energy using the lower electrode arrangement. The device may control the up-beam potential and the down-beam potential to vary and/or set the landing energy of the sub-beams on sample 208. The device may be configured to vary a difference between the up-beam potential and the down-beam potential to control the landing energy of the sub-beams on sample 208. The difference may be zero in some instances, and may be increased to greater than zero when varying the landing energy.

The landing energy may be between approximately 0.2 kV to 5 kV. The landing energy may be set within a range of about 0.5 keV and 2.5 keV. For example, to set the landing energy at either of 0.5 kV and 2.5 kV, potentials V1, V2, and V3 can be applied to the up-beam electrode 301, the down-beam electrode 302, and the upper electrode 303 respectively as indicated in Table 1 below. The potentials applied to the lower electrode arrangement are used to set the landing energy. The potentials in this table are given as values of beam energy in keV, which is equivalent to the electrode potential relative to the cathode of the beam source 201. It will be understood that in designing an electron-optical system there is considerable design freedom as to which point in the system is set to a ground potential and the operation of the system is determined by potential differences rather than absolute potentials. Values are provided in table 1 for example only.

**Table 1**

| | | |
|---|---|---|
| Landing Energy | 0.5 keV | 2.5 keV |
| V1 | -2.55 keV | 2.55 keV |
| V2 | 0.55 keV | 2.55 keV |
| V3 | 30 keV | 30 keV |
| V4 | 0.5 keV | 2.5 keV |
| V5 | 10-100 keV (typically 30 keV) | 10-100 keV (typically 30 keV) |
| V6 | 1-30 keV (e.g. 10 keV) | 1-30 keV (e.g. 10 keV) |
| V7 | 5-100 keV (typically 30 keV) | 5-100 keV (typically 30 keV) |

As shown in the table, the down-beam electrode potential is about the same as the landing energy. As shown, the down-beam electrode potential may be between approximately 0.55 to 2.55 keV. The up-beam electrode potential may be the same as, or higher than he down-beam electrode potential. For example only, the up-beam electrode potential may be 50 V to up to 1000 V higher than the down-beam electrode potential depending on landing energy but also on design geometry. The difference may be greater than this, e.g. up to 2000 V (as shown in the table above), and the difference could be even higher. The up-beam and down-beam electrodes and their potentials are described further below.

As shown in Table 1, when the up-beam and down-beam electrodes are both set to the higher value of 2.55 keV, the landing energy is set at a higher level of approximately 2.5 keV. Whereas, when the up-beam electrode is set to approximately 2.55 keV and the down-beam electrode is set to approximately 0.55 keV, the landing energy is set to a lower level of approximately 0.5 keV. The down-beam electrode potential is preferably similar in magnitude to the landing energy. For example, the down-beam potential may be approximately 50 V more than the landing energy.

The maximum landing energy is determined by the thickness of the lower electrode arrangement (assuming a fixed working distance between the sample and bottom electrode of the objective lens array and a fixed maximum internal field). The maximum landing energy can be increased by increasing the working distance between the sample and the objective lens array 241 or decreasing the internal field, however, this may negatively impact resolution.

The landing energy is at the highest end of this range when there is no potential difference between the up-beam electrode 301 and the down-beam electrode 302 (i.e. when the up-beam electrode potential and the down-beam electrode potential are the same). In this case, there is substantially no field between these electrodes. Thus, the lower electrode arrangement may function in substantially the same way as a single electrode, i.e. the up-beam electrode 301 and the down-beam electrode 302 may effectively act as a single electrode having a thickness which is the same as the dimension of the lower electrode arrangement along the sub-beam path. In this case, the objective lens can function as though including only two electrodes, the upper electrode 303 and an effective lower electrode (formed by the lower electrode arrangement), as described above in relation to the prior art.

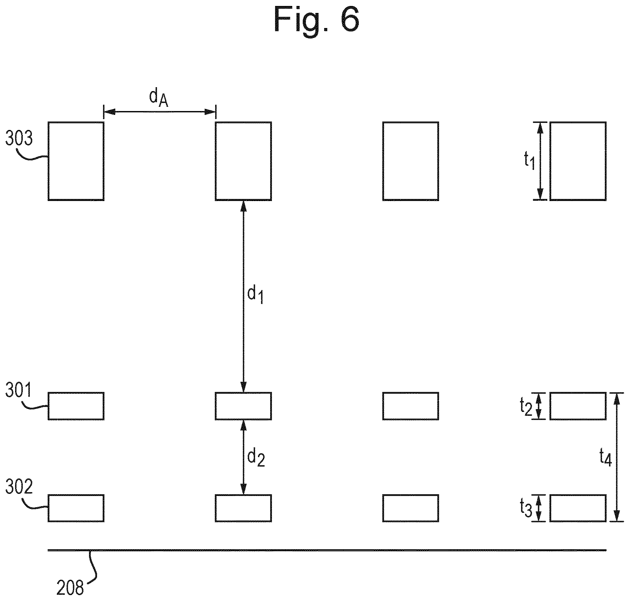

The dimension t4 of the lower electrode arrangement along the sub-beam paths is the thickness of the lower electrode arrangement as shown in FIG. 6. The arrangement may have the following dimensions: the thickness t2 of the up-beam electrode 301; thickness t3 of the down-beam electrode 302, and/or the distance d2 between the up-beam and down-beam electrodes along the beam paths. The dimension t4 of the lower electrode arrangement along the beam paths is the sum of thickness t2, thickness t3, and the distance d2. If the thickness t4 is set to the same value as the lower electrode in the original electrode geometry discussed above, then setting the potentials on the up-beam and down-beam electrodes to the same value means that the same resolution at the highest landing energy can be achieved as with the original electrode geometry because the focal length will not be changed. As described above, the thickness of the lower electrode arrangement can be optimized in such a way that the distance between the top of the up-beam electrode 301 (where the main focusing action takes place) and the sample 208 is about the same as the focal length.

Alternatively, there may be a difference in the up-beam potential and the down-beam potential as shown in Table 1 for the lower landing energy. The difference between the up-beam potential and the down-beam potential may be greater than 0 V and up to and including approximately 2.5 kV. When there is a difference between the up-beam potential and the down-beam potential, the up-beam potential has a larger magnitude than the down-beam potential. The difference in the up-beam potential and the down-beam potential creates an additional lens field between the up-beam electrode 301 and the down-beam electrode 302. The difference between the up-beam potential and the down-beam potential may be between approximately 50 V to 2 kV. The difference between the up-beam potential and the down-beam potential may be between approximately 50 V to 1 kV. The difference between the up-beam potential and the down-beam potential may be between approximately 50 V to 500 V. The difference between the up-beam potential and the down-beam potential may be between approximately 50 V to 300 V.

For the lowest landing energy, the down-beam electrode 302 can be set on the lower landing energy (or 50 V higher as shown by V2 in Table 1) while the sub-beam 211, 212, 213 can be focused on the sample 208 with the potential of the up-beam electrode 301 (VI in Table 1). In this way it is still possible to achieve good resolution also at lower landing energy. It is noted that when the landing energy is reduced the focal length of the deceleration lens becomes smaller (assuming the same internal field strength). If the focal length becomes smaller than the thickness of the bottom electrode arrangement, then the beam is focused inside the bottom electrode arrangement and not on the sample 208. Therefore, the thickness of the bottom electrode arrangement contributes, if not determines, the minimum focal length. Thus, the minimum achievable landing energy may be determined by the minimum achievable thickness of the down-beam electrode.

The up-beam potential and/or down-beam potential can be controlled to vary and/or set the landing energy as described above when the objective lens array is positioned at a predetermined distance from the sample 208. Thus, the device may be configured to adjust the landing energy, even when the distance between the sample 208 and the objective lens array is maintained at a predetermined distance, i.e. neither the sample 208 nor the objective lens array 241 need to move. This is beneficial because changing the distance between the sample 208 and the objective lens may add complexity to the overall system.

When the potential difference between the down-beam electrode 302 and the sample 208 is changed, the electric field on the sample will change which affects the focus of the sub-beam 211, 212, 213 as described above. The change in overall focal length that is caused by this variation in electric field can be corrected in the objective lens array by changing the potential of the up-beam electrode 301 so as to maintain the focus of the sub-beam on the sample 208. Being able to vary the focus is beneficial in providing sub-beams 211, 212, 213 at the desired landing energy with good resolution without having to change the distance between the objective lens array 241 and the sample 208. It is noted that in an objective lens array with the original electrode geometry, either the distance to the sample 208 or the landing energy would need to be changed when the electric field on the sample 208 is varied. Thus, providing the three electrodes in the objective lens array means that the device may be configured to vary and/or set the landing energy whilst maintaining the focus of the beams on the sample. Thus, the landing energy can be varied and/or set whilst having a constant focus so that the focus of the beams is on the sample at different landing energies. In other words, the landing energy can be changed whilst having a constant focus. Thus, the device may be configured to control focus of the sub-beams 211, 212, 213 on the sample 208 at different landing energies, and preferably, maintain focus of the sub-beams 211, 212, 213 on the sample 208. In particular, the up-beam electrode potential can be set to control the field between the up-beam electrode and the down-beam electrode to focus the sub-beam on the sample 208. This allows the focus of the beams on the sample 208 to be maintained irrespective of variation in the landing energy, i.e. the focus can be unaffected by the varying landing energy.

Thus, the lower electrode arrangement can beneficially focus the sub-beams 211, 212, 213 on the sample. This can be beneficial to account for other variations. For example, the distance between the sample 208 and the down-beam electrode 302 may be varied, e.g. to control charging or detection conditions relating to the energy and/or angle of the detected signal particles, and the focus can be adapted and maintained using the lower electrode arrangement as described above. In this case, the voltages on the down-beam electrode 302 and the up-beam electrode may be varied, but the distance between the down-beam electrode 302 and the up-beam electrode may not be varied. Additionally or alternatively, being able to adjust the focus is beneficial in coping in a safe way with samples that have larger height variations than the sample distance proposed for optimum tool performance.

The device may comprise controller 50 to vary and/or set the landing energy. Preferably, the controller 50 is user actuated such that the user can provide an input to the controller 50 and/or device. The input may be the desired landing energy. The controller 50 may receive an indication of the desired landing energy and may control the potentials of at least the up-beam electrode 301 and the down-beam electrode 302 to vary and/or set the landing energy at the desired landing energy. The controller 50 may adjust the up-beam potential to maintain the focus of the sub-beam on the sample.

The potentials applied to each of the objective lens electrodes is in principle the same across each electrode (i.e. substantially uniform across each electrode). For example, the same potential may be applied across the down-beam electrode 302 to each of the sub-beams 211, 212, 213 passing through the down-beam electrode 302. However, variations in the flatness of the electrodes or field curvature effects in the sub-beam can cause focus variations. These variations may be corrected using the potential across the electrodes as will be described herein. For example, the up-beam potential and down-beam potential of different objective lenses across the objective lens array can be set respectively to correct for focus variations between the different objective lenses in the array. Thus, any difference between the up-beam electrode potential and the down-beam electrode potential may be set for different objective lenses across the objective lens array 241. This is beneficial as it allows for more control and more accurate focusing of the beams to account for variation, e.g. due to variations in the flatness of the electrodes or field curvature effects in the sub-beam. The setting of the potentials of different objective lenses of the array can be done for each individual sub-beam, or in groups and/or rings of sub-beams (i.e. for each lens in the array, or in groups and/or rings of lenses). Thus, the focus corrections can be made for each lens individually (i.e. per aperture) for example by each aperture having an electrode for which the applied voltage may be controlled or by using a multipole of array of electrodes around the perimeter of an aperture as described in EP2702595A1 which is herein incorporated by reference so far as multi-pole electrodes; alternatively the focus correction may be in groups (i.e. a group of apertures) for example with a common electrode for each group of apertures. This can be done without changing the distance to the sample 208 or changing the field on the sample 208. This may be applied to any of the embodiments disclosed herein.

The potential on the up-beam electrode 301 may be controllably adjustable across the objective lens array to correct for focus variations between the different objective lenses in the array. This is beneficial as it allows for more control and more accurate focusing of the beams to account for variation, e.g. due to variations in the flatness of the electrodes or field curvature effects in the sub-beam. The setting of the potentials of different objective lenses of the array may be by each lens in the array or by groups of lenses in the array. Thus, the potential of the up-beam electrode 301 may be set individually (i.e. per aperture), or in groups (i.e. a group of apertures) to effect focus corrections; that is each up-beam electrode 301 of the objective lens array may be an individual electrode, or a group of objective lens in the array may have a common up-beam electrode rather, than all objective lenses of the objective lens array having a common up beam electrode 301. This may be applied to any of the embodiments disclosed herein. A distance between the objective lens and the sample and the electric field applied to the sample may be maintained.

The charged particle device may further comprise detector 402 (which may optionally be part of electron detection device 240). The detector 402 is configured to detect signal particles emitted from the sample 208. The signal particles may include any of the charged particles detected by an SEM, including secondary and/or backscattered electrons emitted from the sample 208. The detector 402 may be a detector array comprising multiple detector modules or detecting elements.

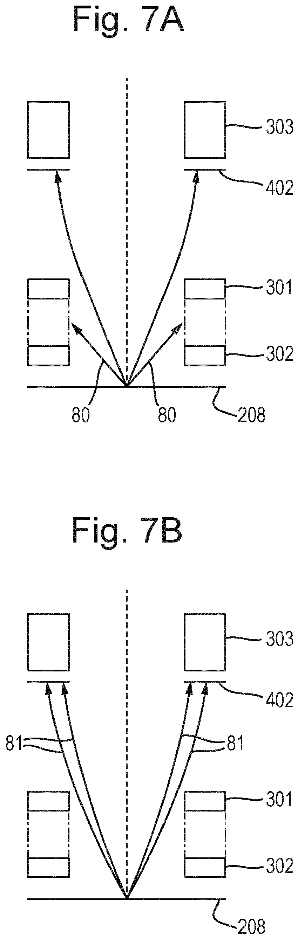

The detector 402, when positioned between electrodes of the objective lens array, may be referred to as in-lens detector. For example, the in-lens detector 402 may be positioned at the bottom of the upper electrode as shown in FIGs 7A and 7B. An in-lens detector may be preferred to a bottom detector in the present invention as it may be difficult to fit a bottom detector between the down-beam electrode 302 and the sample 208. Such a bottom detector may add additional thickness to the bottom electrode arrangement which may impact the performance of the objective lens array. However, with an in-lens detector it can be more difficult to achieve high secondary signal particle collection efficiency than with a bottom detector because of the distance the signal particles have to travel before reaching the in-lens detector.

When the up-beam electrode 301 and the down-beam electrode 302 have substantially the same potential applied (e.g. approximately 2.55 keV) to obtain a high landing energy, there is no field between the up-beam electrode 301 and the down-beam electrode 302. This means that signal particles (e.g. the secondary charged particles) 80 will travel in straight lines between the down-beam electrode 302 and the up-beam electrode 301, possibly hitting the inside of the electrode holes. If detector 402 is provided within the objective lens array, as shown in FIG. 7A, these signal particles will not reach the detector. This could be avoided by making the electrode hole diameter larger, but this limits the achievable minimum sub-beam pitch, and thus, limits the maximum throughput.

In the above embodiment, the objective lens 234 can be used to increase the secondary signal particle detection efficiency without making the hole larger by using the lower electrode arrangement to direct signal charged particles to the detector. This may be done by controlling the potentials of at least the up-beam electrode 301 and the down-beam electrode 302 relative to each other.

In this arrangement, a difference in potential between the up-beam electrode and the down-beam electrode may be applied such that the magnitude of the up-beam potential is larger than the magnitude of the down-beam potential. The difference in potential between the up-beam electrode and the down-beam electrode results in a field between the up-beam electrode 301 and the down-beam electrode 302 which accelerates the signal particles (which are travelling in a direction opposite to the sub-beams 211, 212, 213). The acceleration field diverges signal particles 81, and particularly secondary signal particles, towards the main optical axis of the respective sub-beam path such that the trajectories of the secondary signal particles are generally closer to the main optical axis, as shown in FIG 7B. More specifically, by applying this field between the up-beam and down-beam electrodes, the axial component of the signal particle trajectories is increased (and the radial component may be substantially the same), effectively reducing divergence of the signal particles. This decreases the probability of signal particles hitting the inside of the up-beam electrode 301 and/or the down-beam electrode 302, and increases the probability of the signal particles reaching the in-lens detector 402. Overall, this can increase the collection efficiency at the detector. This can result in a better signal-to-noise ratio enabling higher scan frequencies. It has been found that the efficiency increase is particularly effective when the diameter of apertures in the electrodes is larger, e.g. when apertures have a diameter of approximately 100 microns compared to 50 microns, for example, an aperture that is approximately twice the size of what it would normally be.

It is noted that at lower landing energies there is already a potential difference between the up-beam and down-beam electrodes which leads to an acceleration field present in the proposed configuration. However, providing this acceleration field is especially useful at the highest landing energy when there is usually no field between the up-beam and down-beam electrodes. Even a small difference in potential in this situation may be beneficial in improving detection efficiency. The difference between the up-beam potential and the down-beam potential may be less than or equal to approximately 10% of the down-beam potential. In an arrangement the difference may be approximately 50V to 1000 V, more preferably 50 V to 300 V for example so as to limit the risk to negatively influencing performance of the electron-optical system. For example, the up-beam electrode potential may be approximately 2.75 keV and the down-beam electrode potential may be approximately 2.55 keV. Overall, the difference in potential will be a balance of providing the highest landing energy possible (when there is no potential difference) and introducing a small difference to improve detection efficiency.

Having a larger up-beam potential will change the focus of the beam, which is preferably corrected. This can be done by selecting a larger distance d2 between the up-beam and down-beam electrodes than would otherwise be used, so that there is still a focus on the sample 208 for the highest landing energy when there is an acceleration field between the up-beam and down-beam electrodes. The increased distance d2 may result in somewhat larger aberrations, resulting in a lower sub-beam current if the resolution is kept the same. However, the design can be optimized to balance this decrease in sub-beam current with the increase in signal particle detection efficiency to get the maximum throughput of the system.

The device may be configured in operation to have a difference between the up-beam potential and the down-beam potential which is less than a difference between the up-beam potential and the upper potential. For example, the difference between the up-beam potential and the down-beam potential may be between approximately 0 and 2.5 kV. As described above, this difference may be selected (e.g. adjusted) to control and/or set the landing energy. The difference between the upper electrode potential and the up-beam electrode potential may be substantially the same when the landing energy is varied. There may be a small change in the difference between the upper electrode potential and the up-beam electrode potential when the landing energy is varied. The difference between the upper electrode potential and the up-beam electrode potential may be at least 10 times more that the difference between the up-beam potential and the down-beam potential.

The charged particles may have a negative charge, e.g. the charged particles may be electrons. Therefore, to provide a decelerating field, the upper potential may have a larger magnitude than the up-beam potential and/or the down-beam potential. For example, a magnitude of a difference between the upper potential and the up-beam potential and/or the down-beam potential is approximately 10 kV to 50 kV. The magnitude of the difference between the upper potential and the up-beam potential and/or the down-beam potential may be approximately 20 kV to 40 kV. The difference between the upper potential and the up-beam potential and/or down-beam potential may greater than or equal to approximately 20 kV. The difference between the upper potential and the up-beam potential and/or down-beam potential may be greater than or equal to approximately 25 kV. The difference between the upper potential and the up-beam potential and/or down-beam potential may be approximately 27.45 kV.

Having a larger potential difference between the upper electrode and the up-beam electrode than between the up-beam electrode and the down-beam electrode may be used to control the overall deceleration of the sub-beam using the larger potential difference (between the upper and up-beam electrodes) whilst allowing the landing energy to be tuned using the smaller potential difference (between the up-beam electrode and the down-beam electrode). Resolution becomes better with higher internal electric field and more deceleration (larger potential difference), so that is why there is a large potential difference between the upper electrode and the up-beam electrode. To be able to focus a range of landing energies, a smaller potential difference can be used between the up-beam and down-beam electrode. When this potential difference is smaller than the large potential difference between the upper electrode and the up-beam electrode, then the impact on worsening resolution is limited.

A distance d1 between the upper electrode 303 and the lower electrode arrangement and a dimension t4 of the lower electrode arrangement along the beam paths may be substantially the same. As described above, the dimension t4 of the lower electrode arrangement along the beam paths is the thickness of the lower electrode arrangement as shown in FIG. 6 (i.e. the sum of thickness t2 of the up-beam electrode 301, thickness t3 of the down-beam electrode 302, and the distance d2 between the up-beam and down-beam electrodes). For example, the distance d1 between the upper electrode and the lower electrode arrangement and the dimension t4 of the lower electrode arrangement along the beam paths may be approximately 0.5 to 2 mm. A larger distance d1 means a longer deceleration trajectory which is beneficial for resolution.

The distance d2 between the up-beam electrode 301 and the down-beam electrode 302 may be smaller than a distance d1 between the upper electrode 303 and the lower electrode arrangement. Providing a small distance between the up-beam and down-beam electrode may be beneficial in fitting two electrodes into a smaller space (which might be used for only a single electrode in the prior art). Thus, these electrodes of the lower arrangement, which are positioned relatively close to each other, can be used to control the landing energy and/or focus as described above. The larger d2, the more room there is for fitting the electrodes of the lower electrode arrangement and a larger distance d2 also allows for a larger landing energy range.

The distance d1 between the up-beam electrode 301 and the upper electrode 303 may be approximately 2 to 6 times bigger than the distance d2 between the up-beam electrode 301 and the down-beam electrode 302. The distance d1 between the up-beam electrode 301 and the upper electrode 303 may be approximately 1.1 to 20 times bigger than the distance d2 between the up-beam electrode 301 and the down-beam electrode 302. The distance d1 between the up-beam electrode 301 and the upper electrode 303 may be approximately 1.5 to 10 times bigger than the distance d2 between the up-beam electrode 301 and the down-beam electrode 302. The distance d2 between the up-beam electrode and the down-beam electrode may be approximately 0.3 to 2 mm. The distance d1 between the upper electrode and the lower electrode arrangement may follow, at least approximately, the relationship stated. These distances between the upper electrode 303 and the up-beam electrode 301, and the distance between the up-beam electrode 301 and the down-beam electrode 302 are for example only, and may be selected as appropriate. Thus, other distances may be used.

Further variations which may be applied to any of the above embodiments and/or variations are described below.

The objective lens array 241 may be proximate the sample 208. The objective lens array may therefore be adjacent to the sample 208. Other elements may be provided between the objective lens array 241 and the sample 208. Thus, although the objective lens array 241 is preferably close to the sample 208, it is not a necessity for the objective lens array 241 to be proximate the sample 208.

The device may optionally comprise the control lens array 251 in any of the embodiments or variations. The objective lens array 241 may be down-beam of the control lens array 251.

Generally, there will be a difference between the upper potential and the down-beam and/or up-beam potential. The difference in potential between the upper electrode 303 and the up-beam electrode 301 and/or the down/beam electrode results in a field in the objective lens array that can have a decelerating or accelerating effect on the sub-beams 211, 212, 213. It is noted that a field which decelerates the sub-beams will accelerate signal particles because these beams travel in opposite directions (and vice versa).

The upper electrode 303 may have a thickness t1 that is greater than a thickness t2 of the up-beam electrode 301 and/or a thickness t3 of the down-beam electrode 302. Thus, the upper electrode 303 may have a dimension along the beam path that is greater than a dimension along the beam path of the up-beam electrode 301 and/or the down-beam electrode 302. Preferably, the upper electrode 303 has a thickness t1 (i.e. dimension along the beam path) that is greater than the thickness t2 of the up-beam electrode and the thickness t3 of the down-beam electrode. For example, the upper electrode 303 may have a thickness t1 of approximately 0.1 to 1 mm. For example, the up-beam 301 electrode may have a thickness t2 of approximately 0.1 to 0.2 mm. For example, the down-beam electrode 302 may have a thickness t3 of approximately 0.1 to 0.2 mm. The thickness t2 of the up-beam electrode 301 and the thickness t3 down-beam electrode 302 may be substantially the same.

Generally, for a smaller thickness of the up-beam electrode and the down-beam electrode, a lower minimum landing energy can be obtained. In particular, minimizing the thickness of the electrodes in the lower electrode arrangement is beneficial in allowing for a larger gap (distance d2) between the up-beam electrode 301 and the down-beam electrode 302 which allows for a larger landing energy range. Therefore, the thinner the up-beam and down-beam electrodes are, the better. However, there is a mechanical limit on how thin the electrodes can be. It will be noted that the sub-beam current may be lower when the thickness of the up-beam and down-beam electrodes is lower. Furthermore, it has been found that providing an objective lens with thinner up-beam and down-beam electrodes improves detection efficiency compared to a three electrode objective lens array with three thicker electrodes (for example, similar to the thickness of the upper electrode). This is particularly the case for when apertures in the electrodes have a larger diameter d_{A} than 50 µm, e.g. 100 µm (for example as depicted in FIG. 6) .

The thickness t4 of the lower electrode arrangement (from the top of the up-beam electrode 301 to the bottom of the down-beam electrode 302) may be substantially the same as the thickness t1 of the upper electrode 303. Alternatively, the thickness t4 of the lower electrode arrangement may be substantially different from a distance d1 between the upper electrode and the lower electrode arrangement.

The thickness of the up-beam electrode 301 and the down-beam electrode 302 may be substantially the same.

Although it may be preferred to maintain a predetermined distance between the objective lens array 241 and the sample 208, if preferred, the distance between the sample 208 and the objective lens array 241 may be adjusted as preferred when changing the landing energy, e.g. to focus the sub-beams on the sample 208. The distance between the objective lens array 241 and the sample 208 could be changed by moving the objective lens array 241 and/or the sample 208, or by swapping a modular part of the device comprising at least the objective lens array 241. Parameters of the electrode geometry of the objective lens array 241 in different modules may be different such that the geometry of the electrodes of the objective lens array 241 can be easily swapped using different modules. For example, at least one of the thickness t1, thickness t2, thickness t3, thickness t4, distance d1 and/or distance d2 may differ from one module to the next.

The lower electrode arrangement may be adjacent to the upper electrode 303. Thus, the lower electrode arrangement may be next to the upper electrode 303 along the beam paths. There may not be any other components positioned between the lower electrode arrangement and the upper electrode 303. If an in-lens detector 402 is provided between the lower electrode arrangement and the upper electrode 303, the detector 402 may be adjacent to the lower electrode arrangement and the upper electrode 303. Thus, there may not be any other components between the detector 402 and the lower electrode arrangement, and there may not be any other components between the detector 402 and the upper electrode 303.

As described above, the detector 402 (which may be a detector array) may be positioned between the upper electrode 303 and the lower electrode arrangement. More generally, the detector 402 may be associated with the objective lens array 241. The detector may be part of the objective lens array 241. The detector may be adjacent to, attached to or integrated with at least one of the electrodes of the objective lens array. For example, the detector may be implemented by integrating a CMOS chip detector into an electrode of the objective lens array. Integration of a detector array into the objective lens array replaces a secondary column. The CMOS chip is preferably orientated to face the sample. In an embodiment, detecting elements to capture the signal particles are formed in the top metal layer of the CMOS device. The detecting elements can be formed in other layers. Power and control signals of the CMOS may be connected to the CMOS by through-silicon vias. For robustness, preferably the bottom electrode consists of two elements: the CMOS chip and a passive Si plate with holes. The plate shields the CMOS from high E-fields. Other types of detector may be used in place of a CMOS chip such as a PIN detector or scintillator.

The integrated detector array described above is particularly advantageous when used with a tool having tunable landing energy as signal particle capture can be optimized for a range of landing energies. A detector array can also be integrated into other electrode arrays, not only the lowest electrode array. Further details and alternative arrangements of a detector module integrated into an objective lens can be found in EP Application Number 20184160.8, which document is hereby incorporated by reference with respect to details regarding detector modules and the detectors therewithin.

The detector may be provided on an output side of the objective lens array 241, i.e. on an output side of the objective lens. The detector 402 may be positioned on or adjacent to an upper surface of any one of the electrodes of the objective lens array 241. Thus, the detector may be positioned facing up-beam on an electrode (e.g. the upper electrode 303) of the objective lens array 241 as described in EPA number21174519.5 which document is hereby incorporated by reference with respect to the details of the different detector arrangements.. The detector 402 may be positioned on or adjacent to a lower surface of any one of the electrodes of the objective lens array 241. The detector 402 may be positioned above the objective lens array 241, i.e. the detector 402 may be positioned above all the electrodes of the objective lens array 241. The detector may be positioned between the objective lens array 241 and the control lens array 250 (if provided). The detector may be positioned above and proximate to the objective lens array 241.

For example, it may be beneficial to position the detector 402 just above the upper electrode 303 of the objective lens array 241, for example above even the up-beam surface of the upper electrode 303, to avoid that the detector 402 is in a strong deceleration field starting from below the upper electrode 303. In this case, to keep a good detector collection efficiency, the aperture diameter of the upper electrode 303 could be made large enough (say comparable or larger than the diameter of the detector) to not block any secondary signal particles traveling towards the detector 402.

The detector may be positioned facing towards the sample 208. The detector 402 can be positioned in any appropriate location, including a location not associated with the objective lens array 241. For example, the detector 402 may be positioned below the objective lens array 241. The detector 402 in such a position may otherwise be referred to as a bottom detector. The bottom detector may be proximate the sample 208. The detector may be adjacent to the sample 208. As the distance between sample 208 and the down-beam electrode may be kept the same when changing the landing energy, the bottom detector collection efficiency can be substantially maintained without moving the detector. The bottom detector may have a minimum thickness which may limit the landing energy range. Therefore, it may be preferable to position the detector in other locations. However, for other landing energy ranges or if the thickness of the detector can be decreased, then the bottom detector may be useful.

Multiple detectors may be provided. Thus, multiple detector arrays may be provided at different positions along the sub-beam paths.

A deflector array (not shown) may be positioned between the detector 402 and the objective lens array 241. In an embodiment the deflector array comprises a Wien filter so that deflector array may be referred to as a beam separator. The deflector array may be configured to provide a magnetic field to disentangle the sub-beams (i.e. the charged particles projected to the sample 208) from the signal particles from the sample 208.

In an embodiment the deflector array comprises a magnetic deflector and an electrostatic deflector. The electrostatic deflector is configured to counteract the deflection of the magnetic deflector for the projected charged particle beams transmitted towards the sample 208. Accordingly, the projected charged particle beams may be shifted to a small extent in the horizontal plane. The beams down-beam of the deflector array are substantially parallel to the beams up-beam of the deflector array.

A voltage source may be configured to apply a potential to the detector (as shown for the voltage sources and electrodes in FIG 5). The voltage source applying a potential to the detector may be a separate voltage source from those shown in FIG 5. Alternatively, one of the voltage sources, e.g. V1, V2 or V3 may be used to apply a potential to the detector as well as an appropriate electrode of the objective lens array 241. The potential applied to the detector may be substantially the same as the potential applied to one of the electrodes of the objective lens array. The potential applied to the detector may be substantially the same as the potential applied to a nearest one of the electrodes of the objective lens array for example the electrode with which the detector is associated or even to which it is mechanically connected. For example, when the detector is a bottom array, the potential applied to the bottom detector may be substantially the same as the potential applied to the down-beam electrode 302.

As mentioned, the detector may be a detector array comprising a plurality of detector elements (e.g. sensor elements such as capture electrodes). The plurality of detector elements may be provided in substantially the same plane. The plurality of detectors may be provided in a rectangular array, or may be differently arranged, e.g. in a hexagonal array. At least one detector element may comprise capture electrodes. Each detector element may comprise a single electrode that surrounds each aperture. Alternatively, each detector element may comprise a plurality of electrode elements around each aperture. The signal particles captured by the electrode elements surrounding one aperture may be combined into a single signal or used to generate independent signals. The electrode elements may be divided radially (i.e. to form a plurality of concentric annuli), angularly (i.e. to form a plurality of sections (or sector-like pieces)), both radially and angularly or in any other reasonably conceivable manner.

Generally it may be preferable for the detecting elements to be as large as possible to improve detection efficiency. However, a larger detecting surface leads to a larger parasitic capacitance, so a lower bandwidth. For this reason it may be desirable to limit the outer diameter of the detector elements. Especially in case a larger detector gives only a slightly larger detection efficiency, but a significantly larger capacitance. A circular (annular) detecting element may provide a good compromise between collection efficiency and parasitic capacitance. A larger outer diameter of the electrode may also lead to a larger crosstalk (sensitivity to the signal of a neighboring aperture). This can also be a reason to make the electrode outer diameter smaller. Especially in case a larger electrode gives only a slightly larger detection efficiency, but a significantly larger crosstalk.

The back-scattered and/or secondary electron current collected by a capture electrode may be amplified by an amplifier, e.g. a Trans Impedance Amplifier which may be integrated into a substrate of the detector module in which the capture electrode are provided.

The condenser lens array 231 described above may be part of the device as in any of the above embodiments and variations. The condenser lens array comprises a beam limiting aperture array to generate the array of beams from a source beam (i.e. the beam from the source). The beam limiting aperture array may function as a shaping limiter array 242. Such a beam shaping limiter array shapes the beams. The electron-optical arrangement of the device, for example as depicted in FIG. 3 additionally may comprise at least one aberration corrector. Additionally the device may comprise at least one scan deflector as described previously.

As described in EP Application Number 20158804.3 and International Application Numbers PCT/EP2021/058824 and PCT/EP2021/058823 which are hereby incorporated by reference with respect to correctors and their positioning along the beam path, the device may comprise one or more aberration correctors that reduce one or more aberrations in the sub-beams. Each of at least a subset of the aberration correctors may be positioned in, or directly adjacent to, a respective one of the intermediate foci (e.g. in or adjacent to the intermediate image plane) such as proximate to the collimator array, e.g deflector array 235. The sub-beams have a smallest cross-sectional area in or near a focal plane such as the intermediate plane. This provides more space for aberration correctors than is available elsewhere, i.e. up-beam or down-beam of the intermediate plane (or than would be available in alternative arrangements that do not have an intermediate image plane). Additionally or alternatively the aberration corrector arrays may be located in a lens array such as the condenser lens array and/or the objective lens array, such that the correctors can correct for the aberrations as close as possible to their introduction in the primary beam. The aberration correctors may correct for the source 201 appearing to be at different positions for different beams. The aberration correctors may comprise deflectors for such corrections. Correctors can be used to correct macroscopic aberrations resulting from the source that prevent a good alignment between each sub-beam and a corresponding objective lens.

The aberration correctors may correct aberrations that prevent proper column alignment. Such aberrations may also lead to a misalignment between the sub-beams and the correctors. For this reason, it may be desirable to additionally or alternatively position aberration correctors at or near the condenser lenses of condenser lens array 231 (e.g. with each such aberration corrector being integrated with, or directly adjacent to, one or more of the condenser lenses 231). This is desirable because at or near the condenser lenses of condenser lens array 231 aberrations will not yet have led to a shift of corresponding sub-beams because the condenser lenses are vertically close or coincident with the beam apertures. A challenge with positioning correctors at or near the condenser lenses, however, is that the sub-beams each have relatively large sectional areas and relatively small pitch at this location, relative to locations further downstream. The aberration correctors may be CMOS based individual programmable deflectors as disclosed in EP2702595A1 or an array of multipole deflectors as disclosed EP2715768A2, of which the descriptions of the beamlet manipulators in both documents are hereby incorporated by reference. The aberration correctors and the condenser lenses may be connected to each other, for example, with an electrically isolating element (i.e. a spacer).

In some embodiments, each of at least a subset of the aberration correctors is integrated with, or directly adjacent to, one or more of the objective lenses 234. In an embodiment, these aberration correctors reduce one or more of the following: field curvature; focus error; and astigmatism. Additionally or alternatively, one or more scanning deflectors (not shown) may be integrated with, or directly adjacent to, one or more of the objective lenses 234 for scanning the sub-beams 211, 212, 213 over the sample 208. In an embodiment, the scanning deflectors described in US 2010/0276606, which document is hereby incorporated by reference in its entirety, may be used. The aberration correctors and the objective lenses may be connected to each other, for example, with an electrically isolating element (i.e. a spacer).

In an embodiment, the device is an exchangeable module, either comprising only the objective lens array or including other elements such as the control lens array and/or detector array and/or the stage 209. In an embodiment, the exchangeable module is configured to be replaceable within the charged particle system. The exchangeable module may be field replaceable, i.e. the module can be swapped for a new module by a field engineer. Field replaceable is intended to mean that the module may be removed and replaced with the same or different module while maintaining the vacuum in which the electron beam tool 40 is located. In an embodiment, multiple exchangeable modules are contained within the tool and can be swapped between operable and non-operable positions without opening the tool. In an embodiment, the exchangeable module is a MEMS module.

In a device with an electron-optical arrangement that preferably is different from described above the beam limiting aperture array and function of beam shaping is associated with the objective lens arrangement, as described in EP Application 21166202.8 which is incorporated by reference at least so far as the disclosure of beam limiting apertures and beam shaping apertures. Such an arrangement features a decelerating lens having two electrodes. A beam limiting aperture is either up beam of the first lensing electrode of the objective lens array or is the first lensing electrode of the objective lens array. Such a beam limiting aperture may be referred to as an upper beam limiter 252 as described later herein. The beam limiting aperture array generates the array of beams for the source beam emitted by a source. A beam shaping aperture array can be either associated with (e.g. down beam of) the lensing electrode of the objective lens arrangement for example to provide the down beam most electrode of the objective lens array, or it can be associated with any electrode of the objective lens because of the proximity of these electrodes to the sample. The beam shaping aperture array defines the shape of the beams. For this reason the apertures of the beam shaping array have a smaller diameter than those of the beam limiting array.

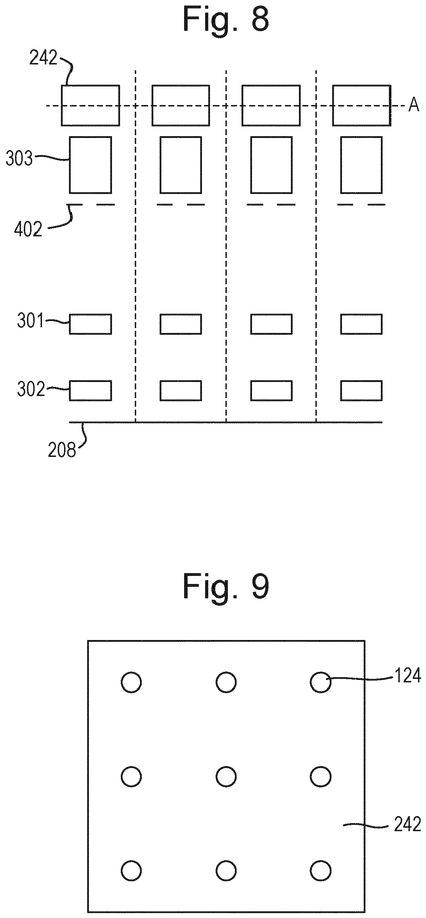

As exemplified in **FIG. 8 and 9****,** a device featuring an objective lens featuring a plurality of bottom electrodes may comprise the beam shaping limiter 242 (otherwise referred to as a beam limiter array). The beam shaping limiter 242 defines an array of beam-limiting apertures 124. The beam shaping limiter 124 is shown as having a 3x3 array of beam-limiting apertures, but could have any appropriate number of beam-limiting apertures 124, for example 100 by 100, and the apertures may have any suitable grid array, for example hexagonal. The beam shaping limiter 242 may be referred to as a beam shaping-limiting aperture array. The beam shaping limiter 242 may comprise a plate (which may be a plate-like body) having a plurality of apertures. The beam shaping limiter 242 is down-beam from at least one electrode (optionally from all electrodes) of the control lens array 250. In some embodiments, the beam shaping limiter 242 is up-beam from at least one electrode (optionally from all electrodes) of the objective lens array 241.

In an arrangement, the beam shaping limiter 242 is associated with (e.g. adjacent to) an electrode (e.g. upper electrode 303) of the objective lens array 241. Desirably, the beam shaping limiter 242 is positioned in a region of low electrostatic field strength. Each of the beam-limiting apertures 124 is aligned with a corresponding objective lens in the objective lens array 241. Each beam-limiting aperture 124 has a beam limiting effect, allowing only a selected portion of the sub-beam incident onto the beam shaping limiter 242 to pass through the beam-limiting aperture 124. The selected portion may be such that only a portion of the respective sub-beam passing through a central portion of respective apertures in the objective lens array reaches the sample 208. The central portion may have a circular cross-section and/or be centered on a beam axis of the sub-beam 211, 212, 213.

In the particular example of **FIGs. 8** and **9****,** the beam shaping limiter 242 is shown as an element formed separately from a upper electrode 303 of the objective lens array 241. Alternatively, the beam shaping limiter 242 may be formed integrally with the upper electrode 303 of an objective lens array 241 (e.g. by performing lithography to etch away cavities suitable for functioning as lens apertures and beam-blocking apertures on opposite sides of the substrate). Although reference is made to the upper electrode 303, the beam shaping limiter 242 may be formed with any of the electrodes of the objective lens array 241.

In an embodiment, the apertures 124 in the beam shaping limiter 242 are provided at a distance up-beam from at least a portion of a corresponding lens aperture in the upper electrode 303 of the corresponding objective lens array 241 by a distance equal to or larger than a diameter of the lens aperture, preferably at least 1.5 times larger than the diameter of the lens aperture, preferably at least 2 times larger than a diameter of the lens aperture.

It is generally desirable to position the beam shaping limiter 242 adjacent to the electrode of each objective lens that has the strongest lensing effect. In the present invention, at least one of the electrodes of the objective lens array 241 may be positioned down-beam of the beam shaping limiter 242. All of the electrodes of the objective lens array 241 may be positioned down-beam of the beam shaping limiter 242. The charged particle device may also be configured to control the objective lens array (e.g. by controlling the potentials applied to the electrodes of the objective lens array) so that the beam shaping limiter 242 is adjacent to or integrated with an electrode of the objective lens array 241 having the strongest lensing effect of the electrodes of the objective lens array 241.

It is generally desirable also to position the beam shaping limiter 242 in a region where the electric field is small, preferably in a substantially field-free region. This avoids or minimizes disruption of a desired lensing effect by the presence of the beam shaping limiter 242.

It is desirable to provide the beam shaping limiter 242 up-beam of the detector 402, as exemplified in **FIG. 8****.** Providing the beam shaping limiter 242 up-beam of the detector ensures that the beam shaping limiter 242 will not obstruct signal particles emitted from the sample 208 and prevent them from reaching the detector 402. In embodiments where the detector 402 is provided up-beam of all of the electrodes of the objective lens array 241, it is therefore desirable also to provide the beam shaping limiter 242 up-beam of all of the electrodes of the objective lens array 241 or even up-beam of one or more of the electrodes of the control lens array 250. In this scenario, it may be desirable to position the beam shaping limiter 242 as close as possible to the objective lens array 241 while still being up-beam of the detector 402. The beam shaping limiter 242 may thus be provided directly adjacent to the detector in the up-beam direction.

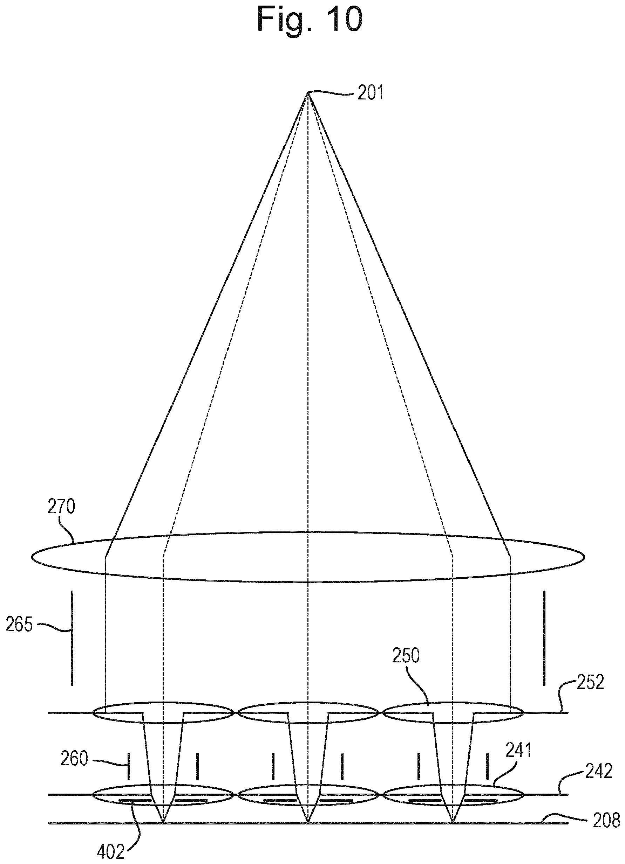

A device having electron-optical arrangement with beam shaping array associated with the objective lens arrangement is shown in **FIG. 10.** FIG. 10 depicts a collimator provided up-beam of the objective lens array 241 and/or the control lens array 250. The collimator may comprise a macro collimator 270. The macro collimator 270 acts on the beam from the source 201 before the beam has been split into a sub-beams. The macro collimator 270 bends respective portions of the beam by an amount effective to ensure that a beam axis of each of the sub-beams derived from the beam is incident on the sample 208 substantially normally (i.e. at substantially 90° to the nominal surface of the sample 208). The macro collimator 270 applies a macroscopic collimation to the beam. The macro collimator 270 may thus act on all of the beam rather than comprising an array of collimator elements that are each configured to act on a different individual portion of the beam. The macro collimator 270 may comprise a magnetic lens or magnetic lens arrangement comprising a plurality of magnetic lens sub-units (e.g. a plurality of electromagnets forming a multi-pole arrangement). Alternatively or additionally, the macro-collimator may be at least partially implemented electrostatically. The macro-collimator may comprise an electrostatic lens or electrostatic lens arrangement comprising a plurality of electrostatic lens sub-units. The macro collimator 270 may use a combination of magnetic and electrostatic lenses..

A macro scan deflector 265 may be provided to cause sub-beams to be scanned over the sample 208. The macro scan deflector 265 deflects respective portions of the beam to cause the sub-beams to be scanned over the sample 208. In an embodiment, the macro scan deflector 256 comprises a macroscopic multi-pole deflector, for example with 8 poles or more. The deflection is such as to cause sub-beams derived from the beam to be scanned across the sample 208 in one direction (e.g. parallel to a single axis, such as an X axis) or in two directions (e.g. relative to two non-parallel axes, such as X and Y axes). The macro scan deflector 265 acts macroscopically on all of the beam rather than comprising an array of deflector elements that are each configured to act on a different individual portion of the beam. In the embodiment shown, the macro scan deflector 265 is provided between the macro collimator 270 and the control lens array 250.

The device may comprise a scan-deflector array 260. The scan-deflector array 260 comprises a plurality of scan deflectors. The scan-deflector array 260 may be formed using MEMS manufacturing techniques. Each scan deflector scans a respective sub-beam over the sample 208. The scan-deflector array 260 may thus comprise a scan deflector for each sub-beam. As shown, both the macro scan deflector 265 and the scan-deflector array 260 may be provided. The scanning of the sub-beams over the sample surface may be achieved by controlling the macro scan deflector 265 and the scan-deflector array 260 together, preferably in synchronization (when both are provided as shown in **FIG. 10**).

Each scan deflector of the scan deflector array 260 may deflect rays in the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). In an embodiment, the scanning deflectors described in EP2425444, which document is hereby incorporated by reference in its entirety specifically in relation to scan deflectors, may be used to implement the scan-deflector array 260. Preferably, the scan-deflector array 260 is positioned between the objective lens array 241 and the control lens array 250.

Although both the scan-deflector array 260 and the macro scan deflector 265 are shown in FIG 10, only one or other of the deflectors may be provided, or neither. For example, the scan-deflector array 260 may be provided without the macro scan deflector 265. For example, the macro scan deflector 265 may be provided without the scan-deflector array 260. A scan-deflector array 260 (e.g. formed using MEMS manufacturing techniques as mentioned above) may be more spatially compact than a macro scan deflector 265.

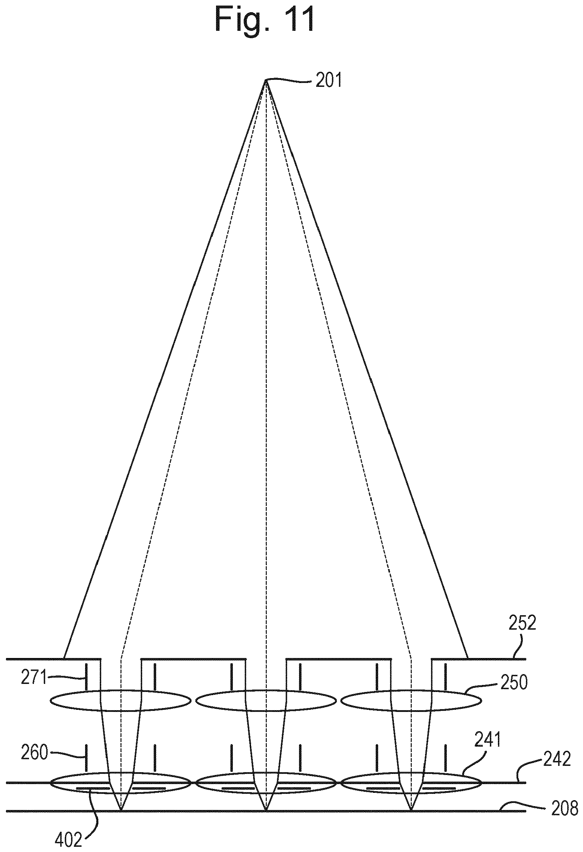

The provision of a scan-deflector array 260 (compared to a macro scan deflector 265) can reduce aberrations from the control lenses. This is because the scanning action of the macro scan deflector 265 causes a corresponding movement of beams over a beam shaping limiter (also referred to as a lower beam limiter) defining an array of beam-limiting apertures down-beam of at least one electrode of the control lenses, which increases a contribution to aberration from the control lenses. When a scan-deflector array 260 is used instead the beams are moved by a much smaller amount over the beam shaping limiter. This is because the distance from the scan-deflector array 260 to the beam shaping limiter is much shorter. Because of this it is preferable to position the scan-deflector array 260 as close as possible to the objective lens array 241 (e.g. such that the scan-deflector array 260 is directly adjacent to the objective lens array 241 as depicted in **FIG. 11****.** The smaller movement over the beam shaping limiter results in a smaller part of each control lens being used. The control lenses thus have a smaller aberration contribution. To minimize, or at least reduce, the aberrations contributed by the control lenses the beam shaping limiter is used to shape beams down beam from at least one electrode of the control lenses. This differs architecturally from conventional systems in which a beam shaping limiter is provided only as an aperture array that is part of or associated with a first manipulator array in the beam path and commonly generates the multi-beams from a single beam from a source.

In some embodiments, the control lens array 250 is the first deflecting or lensing charged particle-optical array element in the beam path down-beam of the source 201.

As shown in **FIG. 11****,** a collimator element array 271 can be provided instead of a macro collimator 270. Although not shown, it is also possible to apply this variation to the embodiment of **FIG. 3****,** to provide an embodiment having a macro scan deflector and a collimator element array. Each collimator element collimates a respective sub-beam. The collimator element array 271 (e.g. formed using MEMS manufacturing techniques) may be more spatially compact than a macro collimator 270. Providing the collimator element array 271 and the scan-deflector array 260 together may therefore provide space saving. This space saving is desirable where a plurality of the electron-optical systems comprising the objective lens array assembly are provided in an electron-optical system array. In this arrangement, there may be no macro condenser lens or a condenser lens array. In this scenario the control lens therefore provides the possibility to optimize the beam opening angle and magnification for changes in landing energy. Additionally, an arrangement without a macro condenser lens, and with a condenser lens array enables the positioning of the beams shaping array, with respect to the electrodes of the objective lens array, to be determined mainly on the position of the strongest lensing electrode of the objective lens array. That is for the beam shaping array to be positioned proximate to or even be the objective lens electrode that has the largest lensing effect.

In some embodiments, as exemplified in **FIG. 11****,** the collimator element array 271 is the first deflecting or focusing charged particle-optical array element in the beam path down-beam of the source 201.

Avoiding any deflecting or lensing electron-optical array elements (e.g. lens arrays or deflector arrays) up-beam of the control lens array 250 or up-beam of the collimator element array 271 reduces requirements for charged particle-optics up-beam of the objective lenses, and for correctors to correct for imperfections in such optics. For example, some alternative arrangements seek to maximize source current utilization by providing a condenser lens array in addition to an objective lens array. The provision of a condenser lens array and an objective lens array in this manner results in stringent requirements on position of the virtual source position uniformity over the source opening angle, or requires corrective optics per sub-beam in order to make sure each sub-beam passes through the center of its corresponding objective lens down-beam. Architectures such as those of **FIGs. 10** and **11** allow the beam path from the first deflecting or lensing electron-optical array element to a beam shaping limiter to be reduced to less than about 10mm, preferably to less than about 5mm, preferably to less than about 2mm. Reducing the beam path reduces or removes the stringent requirements on virtual source position over the source opening angle.

In some embodiments, the system further comprises an upper beam limiter 252. Such an upper beam limiter is shown in **FIG. 10** and **11****.** The upper beam limiter 252 defines an array of beam-limiting apertures. The upper beam limiter 252 may be referred to as an upper beam-limiting aperture array or up-beam beam-limiting aperture array. The upper beam limiter 252 may comprise a plate (which may be a plate-like body) having a plurality of apertures. The upper beam limiter 252 forms sub-beams from a beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

The upper beam limiter may be provided in a system without the condenser lens array 231. The upper beam limiter 252 may, for example, be adjacent to and/or integrated with the control lens array 250 (e.g. adjacent to and/or integrated with an electrode 603 of the control lens array 250 nearest to the source 201). The upper beam limiter 252 may be the most-up-beam electrode of the control lens array 250. In an embodiment, the upper beam limiter 252 defines beam-limiting apertures that are larger (e.g. have larger cross-sectional area) than beam-limiting apertures 124 of the beam shaping limiter 242. The beam-limiting apertures 124 of the beam shaping limiter 242 may thus be of smaller dimension (i.e. smaller area and/or smaller diameter and/or smaller other characteristic dimension) than the corresponding apertures defined in the upper beam limiter 252 and/or in the objective lens array 241 and/or in the control lens array 250.

When the condenser lens array 231 is present, as exemplified in **FIG. 3****,** upper beam limiter 252 may be provided adjacent to and/or integrated with the condenser lens array 231 (e.g. adjacent to and/or integrated with an electrode of the condenser lens array 231 nearest to the source 201).

It is desirable generally to configure the beam-limiting apertures of the beam shaping limiter 242 to be smaller than beam-limiting apertures of all other beam limiters defining beam-limiting apertures up-beam from the beam shaping limiter 242.

The beam shaping limiter 242 is desirably configured to have a beam-limiting effect (i.e. to remove a portion of each sub-beam that is incident on the beam shaping limiter 242). The beam shaping limiter 242 may, for example, be configured to ensure that each sub-beam exiting an objective lens of the objective lens array 241 has passed through the center of the respective objective lens. In contrast to alternative approaches, this effect can be achieved using the beam shaping limiter 242 without requiring a complex alignment procedure to ensure that sub-beams incident onto the objective lenses are well aligned with the objective lenses. Moreover, the effect of the beam shaping limiter 242 will not be disrupted by column alignment actions, source instabilities or mechanical instabilities. Further the beam shaping limiter 242 reduces the length over which the scanning operates on the sub-beams. The distance is reduced to the length of the beam path from the beam shaping limiter 242 to the sample surface.

A ratio of a diameter of a beam-limiting aperture in the upper beam limiter 252 to a diameter of the corresponding beam-limiting aperture 124 in the beam shaping limiter 242 may be equal to or greater than 3, optionally equal to or greater than 5, optionally equal to or greater than 7.5, optionally equal to or greater than 10. In one arrangement, for example, a beam-limiting aperture in the upper beam limiter 252 has a diameter of about 50 microns and a corresponding beam-limiting aperture 124 in the beam shaping limiter 242 has a diameter of about 10 microns. In another arrangement, a beam-limiting aperture in the upper beam limiter 252 has a diameter of about 100 microns and a corresponding beam-limiting aperture 124 in the beam shaping limiter 242 has a diameter of about 10 microns. It is desirable for only the part of the beam that has gone through the center of the objective lens to be selected by the beam-limiting aperture 124; that is for the beam shaping limiter to: shape the incidental beam generated by beam limiting aperture 124; and define the beam down beam in the beam path of the beam shaping aperture that is directed towards the sample 208.

The lower electrode arrangement described above comprises an up-beam electrode and a down-beam electrode. The lower electrode arrangement may comprise at least one additional electrode, e.g. three or more electrodes. In other words, a lower electrode of the prior art may be split into three or more electrodes, rather than two electrodes as described above. However, the number of electrodes in the lower electrode arrangement is limited by the minimum thickness available for the electrodes and the is also limited by the focal length.

Embodiments of the present disclosure provide a charged particle optical device comprising at least the objective lens array. The charged particle optical device may be incorporated into a charged particle system, such as a charged-particle assessment tool. The charged-particle system may be configured to focus a multi-beam on a sample.

In an embodiment, an charged particle system array is provided. The array may comprise a plurality of any of the charged particle systems described herein. Each of the charged particle systems focuses respective multi-beams simultaneously onto different regions of the same sample. Each charged particle system may form sub-beams from a beam of charged particles from a different respective source 201. Each respective source 201 may be one source in a plurality of sources 201. At least a subset of the plurality of sources 201 may be provided as a source array. The source array may comprise a plurality of sources 201 provided on a common substrate. The focusing of plural multi-beams simultaneously onto different regions of the same sample allows an increased area of the sample 208 to be processed (e.g. assessed) simultaneously. The charged particle systems in the array may be arranged adjacent to each other so as to project the respective multi-beams onto adjacent regions of the sample 208. Any number of charged particle systems may be used in the array. Preferably, the number of charged particle system is in the range of from 9 to 200. The charged particle systems may be arranged in a rectangular array or in a hexagonal array. Alternatively, the charged particle system may be provided in an irregular array or in a regular array having a geometry other than rectangular or hexagonal. Each charged particle system in the array may be configured in any of the ways described herein when referring to a charged particle system. As mentioned above, the scan-deflector array 260 and collimator element array 271 are particularly well suited to incorporation into an charged particle system array because of their spatial compactness, which facilitates positioning of the charged particle systems close to each other.

The charged particle system may be an assessment tool. Thus, the charged particle system according to an embodiment of the invention may be a tool which makes a qualitative assessment of a sample (e.g. pass/fail), one which makes a quantitative measurement (e.g. the size of a feature) of a sample, or one which processes data relating to the sample, or one which generates an image of map of a sample. Examples of assessment tools are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). The electron-optical column 40 may be a component of an assessment tool; such as an inspection tool or a metro-inspection tool, or part of an e-beam lithography tool. Any reference to a tool herein is intended to encompass a device, apparatus or system, the tool comprising various components which may or may not be collocated, and which may even be located in separate rooms, especially for example for data processing elements.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g. voltage supplies and/or current supplies) to control the component to manipulate the charged particle beam in this manner. For example, a voltage supply may be electrically connected to one or more components to apply potentials to the components, such as in a non-limited list including the control lens array 250, the objective lens array 241, the condenser lens 231, correctors, collimator element array 271 and scan deflector array 260, under the control of the controller or control system or control unit. An actuatable component, such as a stage, may be controllable to actuate and thus move relative to another components such as the beam path using one or more controllers, control systems, or control units to control the actuation of the component. Furthermore, the controller 50 referred to above may comprise multiple controllers. Each separate controller may include at least one processor. The controllers may be independent in that they function separately. Signals may be sent between different controllers to transfer information and/or data between the controllers.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques).

The system or device of such arrangements as described above may optionally comprise any appropriate components such as an upper beam limiter 252, a macro-collimator, a macro-scan collimator, a collimator element array 271, a control lens array 250, a scan deflector array 260, a beam shaping limiter 242 and/or a detector array 240; one or more of these elements that may be present may be connected to one more adjacent elements with an isolating element such as a ceramic or glass spacer. Such a spacer may be provided between any adjacent electrodes, e.g. in the condenser lens array 231, in the objective lens array 241 and/or the control lens array 250.

Instructions for controlling the device of the present invention may be included in a computer program. For example, a computer program may comprise instructions to instruct the controller 50 to perform the following steps. The controller 50 controls the electron beam apparatus to project an electron beam towards the sample 208. In an embodiment the controller 50 controls at least one electron-optical element (e.g. an array of multiple deflectors or scan deflectors 260, 265) to operate on the electron beam in the electron beam path. Additionally or alternatively, in an embodiment the controller 50 controls at least one electron-optical element (e.g. the detector array 240) to operate on the electron beam emitted from the sample 208 in response to the electron beam.

A method may be provided of projecting an array of charged particle beams towards a sample in a charged particle optical device, the device comprising: a control lens array configured to control a parameter of the array of beams; and an objective lens array configured to project the array of beams onto the sample, the objective lens being down-beam of the control lens and comprising an upper electrode and a lower electrode arrangement comprising an up-beam electrode and a down-beam electrode, the method comprising: providing the array of beams; applying an upper potential to the upper electrode, an up-beam potential to the up-beam electrode and a down-beam potential to the down-beam electrode; and controlling a difference between the up-beam potential and the down-beam potential so as to vary and/or set the landing energy of the beams on the sample.

The method may further comprise controlling the up-beam potential and the down-beam potential so as to maintain focus of the beams on the sample at different landing energies.

A method may be provided of projecting an array of charged particle beams towards a sample using the charged particle optical device as described above.

References to upper and lower, up and down, above and below should be understood as referring to directions parallel to the (typically but not always vertical) up-beam and down-beam directions of the electron beam or multi-beam impinging on the sample 208. Thus, references to up-beam and down-beam are intended to refer to directions in respect of the beam path independently of any present gravitational field. Up-beam being towards the source and down-beam being towards the sample.

Generally, the charges and potentials referred to above are for use with negatively charged particles, e.g. electrons. However, positive charged particles, e.g. positive ions, may be used instead. In this instance, the potentials applied may be adapted accordingly.

For ease of illustration, lens arrays are depicted schematically in FIGs 3, 10, and 11 by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures.

The terms "beam", "sub-beam" and "beamlet" are used interchangeably herein and are understood to encompass any radiation beam derived from a parent radiation beam by dividing or splitting the parent radiation beam. The term "manipulator" is used to encompass any element which affects the path of a beam, sub-beam or beamlet, such as a lens or deflector. References to elements being aligned along a beam path or sub-beam path are understood to mean that the respective elements are positioned along the beam path or sub-beam path. References to optics are understood to mean electron-optics.

Embodiments of the invention are set out in the following numbered clauses:
Clause 1: A charged particle optical device for a charged particle system, the device being configured to project an array of charged particle beams towards a sample, the device comprising: a control lens array configured to control a parameter of the array of beams; and an objective lens array configured to project the array of beams onto the sample, the objective lens array being down-beam of the control lens and comprising: an upper electrode; and a lower electrode arrangement comprising an up-beam electrode and a down-beam electrode, wherein the device is configured to apply an upper potential to the upper electrode, an up-beam potential to the up-beam electrode and a down-beam potential to the down-beam electrode, and is configured to control the up-beam potential and the down-beam potential to vary and/or set the landing energy of the beams on the sample and to maintain focus of the beams on the sample at different landing energies.
Clause 2: The device of clause 1, wherein a difference between the up-beam potential and the down-beam potential is less than a difference between the up-beam potential and the upper potential.
Clause 3: A charged particle optical device for a charged particle system, the device being configured to project an array of charged particle beams towards a sample, the device comprising: an objective lens array configured to project the array of beams onto the sample, the objective lens array being proximate to the sample and comprising: an upper electrode; and a lower electrode arrangement comprising an up-beam electrode and a down-beam electrode, the device being configured to apply an upper potential to the upper electrode, an up-beam potential to the up-beam electrode and a down-beam potential to the down-beam electrode, and being configured to control a difference between the up-beam potential and the down-beam potential to vary and/or set the landing energy of the beams on the sample, wherein the device is configured in operation to have a difference in magnitude between the up-beam potential and the down-beam potential less than a difference in magnitude between the up-beam potential and the upper potential.
Clause 4: The device of any one of the preceding clauses, wherein a distance between the up-beam electrode and the down-beam electrode is smaller than a distance between the upper electrode and the lower electrode arrangement.
Clause 5: A charged particle optical device for a charged particle system, the device being configured to project an array of charged particle beams towards a sample, the device comprising: an objective lens array configured to project the array of beams onto the sample, the objective lens being proximate to the sample and comprising: an upper electrode; and a lower electrode arrangement comprising an up-beam electrode and a down-beam electrode, the device being configured to apply an upper potential to the upper electrode, an up-beam potential to the up-beam electrode and a down-beam potential to the down-beam electrode, wherein a distance between the up-beam electrode and the down-beam electrode is smaller than a distance between the upper electrode and the lower electrode arrangement.
Clause 6: The device of either of clauses 4 or 5, wherein the distance between the up-beam electrode and the upper electrode is approximately 2 to 6 times bigger than the distance between the up-beam electrode and the down-beam electrode.
Clause 7: The device of any one of the preceding clauses, wherein the charged particle beams are projected along beam paths and a distance between the upper electrode and the lower electrode arrangement and a dimension of the lower electrode arrangement along the beam paths are substantially the same.
Clause 8: A charged particle optical device for a charged particle system, the device being configured to project an array of charged particle beams along beams paths towards a sample, the device comprising: an objective lens array configured to project the array of beams onto the sample, the objective lens being proximate to the sample and comprising: an upper electrode; and a lower electrode arrangement comprising an up-beam electrode and a down-beam electrode, the device being configured to apply an upper potential to the upper electrode, an up-beam potential to the up-beam electrode and a down-beam potential to the down-beam electrode, wherein a distance between the upper electrode and the lower electrode arrangement and a dimension of the lower electrode arrangement along the beam paths are substantially the same.
Clause 9: The device of any one of the preceding clauses, wherein the up-beam potential and the down-beam potential of different objective lenses across the objective lens array are configured to be set respectively to correct for focus variations between the different objective lenses in the array.
Clause 10: The device of any one of the preceding clauses, wherein the potential on the up-beam electrode is configured to be controllably adjusted across the objective lens array to correct for focus variations between the different objective lenses in the array.
Clause 11: A charged particle optical device for a charged particle system, the device being configured to project an array of charged particle beams towards a sample, the device comprising: an objective lens array configured to project the array of beams onto the sample, the objective lens being proximate to the sample and comprising: an upper electrode; and a lower electrode arrangement comprising an up-beam electrode and a down-beam electrode, the device being configured to apply an upper potential to the upper electrode, an up-beam potential to the up-beam electrode and a down-beam potential to the down-beam electrode, and being configured to control the up-beam potential and the down-beam potential, wherein the up-beam potential and the down-beam potential of different objective lenses across the objective lens array are configured to be set respectively to correct for focus variations between the different objective lenses in the array.
Clause 12: The device of clause 11, wherein the potential on the up-beam electrode is configured to be controllably adjusted.
Clause 13: A charged particle optical device for a charged particle system, the device being configured to project an array of charged particle beams towards a sample, the device comprising: an objective lens array configured to project the array of beams onto the sample, the objective lens being proximate to the sample and comprising: an upper electrode; and a lower electrode arrangement comprising an up-beam electrode and a down-beam electrode, the device being configured to apply an upper potential to the upper electrode, an up-beam potential to the up-beam electrode and a down-beam potential to the down-beam electrode, and being configured to control the up-beam potential and the down-beam potential, wherein the potential on the up-beam electrode is configured to be controllably adjusted across the objective lens array to correct for focus variations between the different objective lenses in the array.
Clause 14: The device of clause 13, wherein the difference between the up-beam potential and the down-beam potential of different objective lenses across the objective lens array are configured to be set respectively to correct for focus variations between the different objective lenses in the array.
Clause 15: The device of any one of clauses 9 to 14, wherein the setting of the potentials of different objective lenses of the array is by each lens in the array or by groups of lenses in the array.
Clause 16: The device of any one of clauses 9 to 15, wherein a distance between the objective lens and the sample is configured to be maintained.
Clause 17: The device of any one of clauses 3, 5, 8, or 11-16, wherein the device is configured to control the up-beam potential and the down-beam potential to vary and/or set the landing energy of the beams on the sample, and optionally to control the up-beam potential and the down-beam potential to maintain focus of the beams on the sample at different landing energies.
Clause 18: The device of any one of clauses 3, 5, 8, or 11-17, further comprising a control lens, wherein the objective lens array is down-beam of the control lens array.
Clause 19: The device of any one of clauses 1, 2, 4, 7, 9, 10, or 15-18, wherein the control lens array and objective lens array are spaced apart and connected by an electrically insulating spacer, wherein the spacer comprises ceramic or glass.
Clause 20: The device of any one of the clauses 1, 2, 4, 7, 9, 10, or 15-19, wherein the control lens comprises electrodes which are spaced apart and connected by an electrically insulating spacer, wherein the spacer comprises ceramic or glass.
Clause 21: The device of any preceding clause, wherein the charged particles have a negative charge and the upper potential has a larger magnitude than the up-beam potential and the down-beam potential.
Clause 22: The device of any one of the preceding clauses, wherein a magnitude of a difference between the upper potential and the up-beam potential is approximately 10 kV to 50 kV, or preferably, approximately 20 kV to 40 kV.
Clause 23: The device of any one of the preceding clauses, wherein a thickness of the up-beam electrode is less than a thickness of the upper electrode.
Clause 24: The device of any one of the preceding clauses, wherein a thickness of the down-beam electrode is less than a thickness of the upper electrode.
Clause 25: The device of any of the preceding clauses, wherein the thickness of the up-beam electrode and the down-beam electrode are substantially the same.
Clause 26: The device of any one of the preceding clauses, wherein a thickness of the lower electrode arrangement is substantially the same as a distance between the upper electrode and the lower electrode arrangement.
Clause 27: The device of any one of clauses 1 to 25, wherein a thickness of the lower electrode arrangement is substantially different from a distance between the upper electrode and the lower electrode arrangement.
Clause 28: The device of any one of the preceding clauses, the up-beam electrode has a thickness of approximately 0.1 to 0.2 mm and/or the down-beam electrode has a thickness of approximately 0.1 to 0.2 mm
Clause 29: The device of any one of the preceding clauses, wherein a distance between the up-beam electrode and the down-beam electrode is approximately 0.3 to 2 mm
Clause 30: The device of any one of the preceding clauses, wherein the device further comprises a detector.
Clause 31: The device of clause 30, wherein the detector is positioned between the upper electrode and the lower electrode arrangement and/or is facing the sample.
Clause 32: The device of either of clause 30 or 31, wherein the lower electrode arrangement is configured to direct signal charged particles to the detector.
Clause 33: The device of any one of the preceding clauses, wherein there is a difference between the up-beam potential and the down-beam potential.
Clause 34: The device of clause 33, wherein the up-beam potential has a greater magnitude than the down-beam potential.
Clause 35: The device of either of clauses 33 or 34, wherein the difference between the up-beam potential and the down-beam potential is greater than 0V and up to approximately 2.5 kV.
Clause 36: The device of any one of clauses 1 to 32 wherein the up-beam potential is substantially the same as the down-beam potential.
Clause 37: The device of any one of the preceding clause, wherein electrodes of the objective lens array are spaced apart and connected by an electrically insulating spacer, wherein the spacer comprises ceramic or glass.
Clause 38: The device of any one of the preceding clauses, wherein the device is configured to vary and/or set the landing energy by controlling up-beam potential and down-beam potential when the objective lens array is positioned at a predetermined distance from the sample.
Clause 39: The device of any one of the preceding clauses, wherein the landing energy is between approximately 0.2 kV to 5 kV.
Clause 40: The device of any one of the preceding clauses, further comprising a power supply to set one or more potentials of the device.
Clause 41: The device of any one of the preceding clauses, wherein the device comprises a controller to vary and set the landing energy, preferably wherein the controller is user actuated.
Clause 42: The device of any one of the preceding clauses, wherein the electric field applied to the sample is configured to be maintained.
Clause 43: The device of any one of the preceding clauses, wherein the lower electrode arrangement is adjacent to the upper electrode.
Clause 44: The device of any one of the preceding clauses further comprising a condenser lens array, and/or a beam limiter array and/or a deflector array.
Clause 45: A method of projecting an array of charged particle beams towards a sample in a charged particle optical device, the device comprising: a control lens array configured to control a parameter of the array of beams; and an objective lens array configured to project the array of beams onto the sample, the objective lens being down-beam of the control lens and comprising an upper electrode and a lower electrode arrangement comprising an up-beam electrode and a down-beam electrode, the method comprising: providing the array of beams; applying an upper potential to the upper electrode, an up-beam potential to the up-beam electrode and a down-beam potential to the down-beam electrode; and controlling the up-beam potential and the down-beam potential so as to vary and/or set the landing energy of the beams on the sample and to maintain focus of the beams on the sample at different landing energies.
Clause 46. A method of projecting an array of charged particle beams towards a sample using the charged particle optical device of any one of clauses 1 to 44.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims.

## Claims

1. A charged particle optical device for a charged particle system, the device being configured to project an array of charged particle beams towards a sample, the device comprising:
a control lens array configured to control a parameter of the array of beams; and
an objective lens array configured to project the array of beams onto the sample, the objective lens array being down-beam of the control lens and comprising:
an upper electrode; and
a lower electrode arrangement comprising an up-beam electrode and a down-beam
electrode,
wherein the device is configured to apply an upper potential to the upper electrode, an up-beam potential to the up-beam electrode and a down-beam potential to the down-beam electrode, and is configured to control the up-beam potential and the down-beam potential to vary and/or set the landing energy of the beams on the sample and to maintain focus of the beams on the sample at different landing energies.

2. The device of claim 1, wherein a difference between the up-beam potential and the down-beam potential is less than a difference between the up-beam potential and the upper potential.

3. The device of claim 1 or 2, wherein a distance between the up-beam electrode and the down-beam electrode is smaller than a distance between the upper electrode and the lower electrode arrangement.

4. The device of claim 3, wherein the distance between the up-beam electrode and the upper electrode is approximately 2 to 6 times bigger than the distance between the up-beam electrode and the down-beam electrode.

5. The device of any of the preceding claims, wherein the charged particle beams are projected along beam paths and a distance between the upper electrode and the lower electrode arrangement and a dimension of the lower electrode arrangement along the beam paths are substantially the same.

6. The device of any of the preceding claims, wherein the up-beam potential and the down-beam potential of different objective lenses across the objective lens array are configured to be set respectively to correct for focus variations between the different objective lenses in the array.

7. The device of any of the preceding claims, wherein the potential on the up-beam electrode is configured to be controllably adjusted across the objective lens array to correct for focus variations between the different objective lenses in the array.

8. The device of claim 6 or 7, wherein the setting of the potentials of different objective lenses of the array is by each lens in the array or by groups of lenses in the array.

9. The device of any of claims 6 to 8, wherein a distance between the objective lens and the sample is configured to be maintained.

10. The device of claim 8 or 9, wherein the device is configured to control the up-beam potential and the down-beam potential to vary and/or set the landing energy of the beams on the sample, and optionally to control the up-beam potential and the down-beam potential to maintain focus of the beams on the sample at different landing energies.

11. The device of any of claims 8 to 10, further comprising a control lens, wherein the objective lens array is down-beam of the control lens array.

12. The device of any of the preceding claims, wherein a thickness of the up-beam electrode is less than a thickness of the upper electrode and/or a thickness of the down-beam electrode is less than a thickness of the upper electrode.

13. The device of any of the preceding claims, wherein the thickness of the up-beam electrode and the down-beam electrode are substantially the same.

14. The device of any one of the preceding claims, wherein a thickness of the lower electrode arrangement is substantially the same as a distance between the upper electrode and the lower electrode arrangement.

15. The device of any one of the preceding claims, wherein the device further comprises a detector.
